(19) Europäisches Patentamt
European Patent Office
Office européen des brevets

(11) EP 3 461 233 A1

(12) EUROPEAN PATENT APPLICATION
published in accordance with Art. 153(4) EPC

(43) Date of publication:
**27.03.2019 Bulletin 2019/13**

(21) Application number: **17843278.7**

(22) Date of filing: **21.07.2017**

(51) Int Cl.:
***H05B 33/12*** *(2006.01)* ***G02B 5/20*** *(2006.01)*
***G02B 5/22*** *(2006.01)* ***G02B 5/28*** *(2006.01)*
***H01L 51/50*** *(2006.01)* ***H05B 33/04*** *(2006.01)*

(86) International application number:
**PCT/JP2017/026424**

(87) International publication number:
**WO 2018/037791 (01.03.2018 Gazette 2018/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **24.08.2016 JP 2016163397**

(71) Applicant: **Konica Minolta, Inc.**
**Tokyo 100-7015 (JP)**

(72) Inventors:
- **KOJIMA Shigeru**
  **Tokyo 100-7015 (JP)**
- **KON Shusaku**
  **Tokyo 100-7015 (JP)**
- **KUROKI Takaaki**
  **Tokyo 100-7015 (JP)**
- **HAKII Takeshi**
  **Tokyo 100-7015 (JP)**
- **SEKINE Koujirou**
  **Tokyo 100-7015 (JP)**
- **OSAWA Kou**
  **Tokyo 100-7015 (JP)**

(74) Representative: **Gille Hrabal**
**Brucknerstrasse 20**
**40593 Düsseldorf (DE)**

(54) **ORGANIC ELECTRO-LUMINESCENCE EMISSION DEVICE**

(57) Provided is an organic electro-luminescence emission device wherein a color adjustment layer causes the chroma C* of transmitted light from the organic electro-luminescence emission device when not emitting light to be less than that of transmitted light from an organic electro-luminescence emission device not having a color adjustment layer when not emitting light, thus allowing the chroma of the transmitted light at non-emitting time to approach 0.

FIG. 1

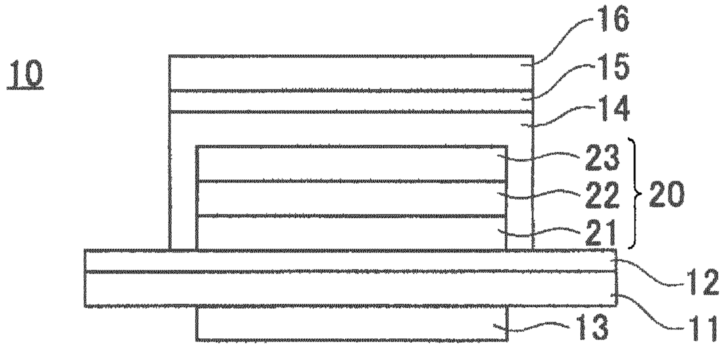


EP 3 461 233 A1

**Description**

Technical Field

The present invention relates to an organic electro-luminescence emission device having optical transparency.

Background Art

An organic electro-luminescence (EL) emission device including an organic EL element has been practically used as an emission device allowing plane emission. Furthermore, a transparent organic EL emission device is demanded as a form of the organic EL emission device in various applications such as displays, buildings, and car windows (for example, see PTL 1).

Citation List

Patent Literature

[PTL 1] Japanese Unexamined Patent Application Publication No. 2007-184279

Summary of Invention

Technical Problem

In the transparent organic EL emission device, however, light is transmitted by the organic EL emission device during no light emission, and such transmitted light may be interfered with a layer configuration or absorbed by a material of the organic EL element so as to be unintentionally colored. That is, the transmitted light during no light emission of the transparent organic EL emission device may have a higher chroma than a neutral color (chroma 0, achromatic color). This leads to an unpreferable appearance of the transparent organic EL emission device; hence, it is required that the chroma of the transmitted light during no light emission is reduced to be close to the neutral color.

In the case that a color filter or the like is intentionally used in the transparent organic EL emission device to give a special appearance, the transparent organic EL emission device has a color different from a desired color of the color filter or the like when light transmitted by the transparent organic EL emission device itself has a high chroma.

Thus, it is required for the transparent organic EL emission device to bring the chroma of the transmitted light close to 0 during no light emission.

To solve the above-described problem, the present invention provides an organic electro-luminescence emission device that can bring the chroma of the transmitted light close to 0 during no light emission.

Solution to Problem

An organic electro-luminescence emission device of the present invention includes a substrate, an organic electro-luminescence element, and a color adjustment layer, in which the color adjustment layer reduces chroma C*, which is given by Formula (1), of transmitted light during no light emission of the organic electro-luminescence emission device compared with transmitted light during no light emission of the organic electro-luminescence emission device having a configuration without the color adjustment layer. In the Formula (1), a* and b* are each a color coordinate stipulated by CIE1976.
Numerical Formula (1)

Formula (1)

$$C^* = \sqrt{a^{*2} + b^{*2}}$$

Advantageous Effects of Invention

According to the present invention, it is possible to provide an organic electro-luminescence emission device that can bring a color of transmitted light close to neutral color during no light emission.

Brief Description of Drawings

Fig. 1 illustrates a configuration of an organic EL emission device of a first embodiment.
Fig. 2 illustrates a planar arrangement of the organic EL emission device of the first embodiment.
Fig. 3 illustrates a planar arrangement of the organic EL emission device of the first embodiment.
Fig. 4 illustrates a configuration of an organic EL emission device of a second embodiment.
Fig. 5 illustrates a configuration of an organic EL emission device of a third embodiment.
Fig. 6 illustrates measurement positions of chroma C* in an example.
Fig. 7 illustrates each position at which a color adjustment layer is provided in a fourth example.

Description of Embodiments

Hereinafter, modes for carrying out the present invention will be exemplarily, but not limitedly, described.
The description is given in the following order.

1. Embodiment of transparent organic electro-luminescence emission device (first embodiment)
2. Embodiment of transparent organic electro-luminescence emission device (second embodiment)
3. Embodiment of transparent organic electro-luminescence emission device (third embodiment)

1. Embodiment of Transparent Organic Electro-Luminescence Emission Device (First Embodiment)

Hereinafter, specific embodiments of the organic electro-luminescence emission device (hereinafter, referred to as organic EL emission device) are described. Fig. 1 shows a schematic configuration diagram of the organic EL emission device of a first embodiment. An organic EL emission device 10 of Fig. 1 is a transparent organic EL emission device. In the following description, transparent corresponds to a total light transmittance, stipulated in JIS K 7375, of 30% or more.
The organic EL emission device 10 of Fig. 1 includes a substrate 11, on which a first barrier layer 12 is formed, and an organic electro-luminescence (EL) element 20 formed on the substrate 11. The organic EL element 20 includes a first electrode (transparent electrode) 21, a light emitting unit 22 formed on the first electrode 21, and a second electrode (transparent electrode) 23 holding the light emitting unit 22 in cooperation with the first electrode 21.
The organic EL emission device 10 further includes an adhesive layer 14 covering the side surfaces and the upper surface of the organic EL element 20 on the substrate 11 having the first barrier layer 12 thereon. A sealing substrate 16 having a second barrier layer 15 thereon is laminated to the substrate 11 and the organic EL element 20 with the adhesive layer 14 therebetween. In this configuration, the organic EL element 20 is sealed by the substrate 11 having the first barrier layer 12 thereon, the adhesive layer 14, and the sealing substrate 16 having the second barrier layer 15 thereon.
In the organic EL emission device 10, a color adjustment layer 13 is provided on a surface (back surface) opposite to the surface, on which the organic EL element 20 is provided, of the substrate 11. The color adjustment layer 13 has a function of bringing chroma of light transmitted by the organic EL emission device 10 close to 0 (neutral color). Specifically, the color adjustment layer 13 has an effect of reducing chroma C*, which is given by Formula (1), of transmitted light during no light emission of the organic EL emission device 10 compared with transmitted light during no light emission of the organic EL emission device 10 having a configuration without the color adjustment layer 13. In the Formula (1), a* and b* are each a color coordinate stipulated by CIE1976.
Numerical Formula 2

Formula (1)

$$C^* = \sqrt{a^{*2} + b^{*2}}$$

The chroma C* is determined by measuring light transmitted by the organic EL emission device 10 using a spectrophotometer U-4100 from Hitachi, Ltd. (with an integrating sphere), and calculating values a* and b* in the CIE 1976 L*a*b* color space by a method according to JIS Z 8781-4 (2013). The measurement is performed at any five or more points, and the average is obtained as a measured value. Specifically, in a region having the electrodes, the measurement is performed at any four or more points along the outer circumference in the region and at one or more point near the center of the light emitting region, and the average is obtained. In a region having no electrode, the

measurement is performed at any five or more points in a region other than the region having the electrodes, and the average is obtained.

The region having the electrodes (which may be referred to as electrode formation region hereinafter) means a region where the first electrode 21 and the second electrode 23 are opposed to (overlap with) each other in a thickness direction. The electrode formation region therefore does not include a region that is formed outside the region where the electrodes are opposed to each other, and has an external connection electrode, an auxiliary electrode, or a conductive layer such as an interconnection formed therein.

The amount of change $\Delta C^*$ in chroma $C^*$ by the color adjustment layer 13 is determined by Formula (2) using values $a^*_1$ and $b^*_1$ determined from the average of values at any five or more points as with the chroma $C^*$, and values $a^*_2$ and $b^*_2$ determined from the average of values at any five or more points in the same region as the above-described region of the organic EL emission device 10 having the configuration without the color adjustment layer 13.

Numerical Formula 3

Formula (2)

$$\Delta C^* = \sqrt{(a^*_1 - a^*_2)^2 + (b^*_1 - b^*_2)^2}$$

Preferably, the organic EL emission device 10 has the color adjustment layer 13, which reduces the chroma $C^*$ given by the Formula (1), in the electrode formation region. The transmitted light has a variable color tone and easily increasing chroma in the electrode formation region, in which the first electrode 21 and the second electrode 23 overlap with each other. This is probably because the first electrode 21 and the second electrode 23 to configure the organic EL element 20 are formed of a metal thin film or metal oxide, and thus greatly affect the transmitted light and tend to affect the chroma of the transmitted light. A portion having an opaque (transmittance of less than 30%) component in the electrode formation region, for example, a portion having an opaque electrode for external connection or an insulating layer is not included in the electrode formation region for measurement of the chroma $C^*$.

Hence, the chroma of the electrode formation region, in which the chroma of the transmitted light tends to vary, is brought close to 0 (neutral color), thereby the chroma of the organic EL emission device 10 as a whole also tends to be close to 0 (neutral color). In the electrode formation region of the organic EL emission device 10, therefore, the color adjustment layer 13 preferably has an effect of reducing the chroma $C^*$ given by the Formula (1) of the transmitted light during no light emission compared with the transmitted light during no light emission of the organic EL emission device 10 having the configuration without the color adjustment layer 13.

Figs. 2 and 3 show planar arrangement of formation regions of the substrate 11, the first electrode 21, the second electrode 23, and the color adjustment layer 13 of the organic EL emission device 10. As shown in Fig, 2, in the organic EL emission device 10, the formation region of the color adjustment layer 13 is preferably formed in a region covering the entire electrode formation region. Further, as shown in Fig. 3, the amount of misregistration is preferably equal to or within $\pm 5\%$ in planar arrangement between the formation region of the color adjustment layer 13 and the electrode formation region. Such arrangement of the color adjustment layer 13 tends to reduce a difference in chroma between the electrode formation region and other region, and tends to improve quality of the organic EL emission device 10.

As described above, the transmitted light has a variable color tone and easily increasing chroma in the electrode formation region. The color adjustment layer 13 is therefore preferably provided at a position so as to cover the entire electrode formation region in which the chroma of the transmitted light tends to vary. This makes it easy to reduce the chroma of the transmitted light in the electrode formation region, and bring the chroma of the transmitted light close to 0 (neutral color) during no light emission of the organic EL emission device 10.

In the organic EL emission device 10, the transmitted light is less affected in the region (which may be referred to as non-electrode-formation region hereinafter), in which the substrate 11, the sealing substrate 16, the first barrier layer 12, and the second barrier layer 15 are formed, other than the electrode formation region, in which the first electrode 21 and the second electrode 23 are opposed to each other, than in the electrode formation region. Hence, the chroma less varies, which is substantially 0, in the non-electrode-formation region than in the electrode formation region. In the organic EL emission device 10, therefore, a difference in chroma tends to occur between the electrode formation region and the non-electrode-formation region.

A position of the electrode formation region is therefore brought in line with a position of the formation region of the color adjustment layer 13 to exclusively reduce the chroma of the light transmitted through the electrode formation region, so that the chroma of the electrode formation region can be brought close to the chroma of the region (non-electrode-formation region) in which the first electrode 21 and the second electrode 23 are not formed. This makes it possible to bring the chroma of the transmitted light close to 0 (neutral color) during no light emission in the entire organic EL emission device 10, and suppress occurrence of a difference in chroma in a plane of the organic EL emission device 10.

When the position of the electrode formation region is brought in line with the position of the formation region of the color adjustment layer 13, formation area of the color adjustment layer 13 is preferably made as small as possible in the region in which the first electrode 21 and the second electrode 23 are not formed. In particular, the amount of misregistration is controlled to be equal to or within ±5%, which reduces visibility of the above-described in-plane chroma difference to the extent that the organic EL emission device 10 has a good appearance. Considering influence of an electrode or a lead of the electrode formed outside the emission region for each of the first electrode 21 and the second electrode 23, the formation area of the color adjustment layer 13 is preferably larger by +5% or less than area of a light emitting part. Furthermore, considering dimensional tolerance and the like in manufacturing of the organic EL emission device 10, the organic EL emission device 10 can be easily manufactured if a condition of misregistration is equal to or within ±5%.

The organic EL emission device 10 preferably includes the color adjustment layer 13 that can reduce by at least 30% the chroma C* given by the Formula (1) of the transmitted light during no light emission compared with the transmitted light during no light emission of the organic EL emission device 10 having the configuration without the color adjustment layer 13. If the chroma of the formation region of the color adjustment layer 13 can be reduced by at least 30%, the difference in chroma between the electrode formation region and other region, i.e., the non-electrode-formation region, can be adjusted within a preferable range. Specifically, it is possible to reduce a difference in chroma of the transmitted light during no light emission of the organic EL emission device 10 between the region in which the first electrode 21 and the second electrode 23 are not formed while the color adjustment layer 13 is formed, the region in which the first electrode 21, the second electrode 23, and the color adjustment layer 13 are formed, and the region in which any of the first electrode 21, the second electrode and 23, and the color adjustment layer 13 is not formed.

The chroma C* of the formation region of the color adjustment layer 13 can be reduced by at least 30%. This means that the chroma C* may be reduced by at least 30% at any measurement point in a planar direction of the organic EL emission device 10, and does not mean a condition required for the entire formation region of the color adjustment layer 13. The organic EL emission device 10 preferably includes the color adjustment layer 13 that can reduce the chroma C* by at least 30% as the average of values measured at five or more points, and more preferably includes the color adjustment layer 13 that can reduce the chroma C* by at least 30% at any measurement point.

The organic EL emission device 10 preferably includes the color adjustment layer 13 that can reduce, by at least 30%, the chroma C* of the formation region of the color adjustment layer 13 in the region where the first electrode 21 and the second electrode 23 are formed. For example, when the color adjustment layer 13 that reduces the chroma C* of the electrode formation region by at least 30% in a configuration where the color adjustment layer 13 is disposed over the entire area of the organic EL emission device 10 of Fig. 2, the chroma of the electrode formation region is reduced, and the chroma of the non-electrode-formation region having the color adjustment layer 13 is affected by both the original chroma of the non-electrode-formation region and the chroma of the color adjustment layer 13 itself. At this time, the chroma of the non-electrode-formation region may not be reduced by at least 30%. However, since the original chroma of the non-electrode-formation region and the chroma of the color adjustment layer 13 itself are each not high compared with that of the electrode formation region, even if the chroma C* of the region other than the electrode formation region is not reduced by at least 30%, the difference in chroma is small between the electrode formation region and the non-electrode-formation region. It is therefore possible to sufficiently reduce the difference in chroma between the electrode formation region and the non-electrode-formation region to the extent that visibility is reduced to configure the organic EL emission device 10 having a good appearance.

Furthermore, the configuration as shown in Fig. 3, in which the color adjustment layer 13 is disposed so as to be in line with the electrode formation region, reduces the chroma of the light transmitted through the electrode formation region in which the chroma tends to increase, and less affects the non-electrode-formation region in which the chroma is less likely to increase. In the configuration as shown in Fig. 3, therefore, the chroma C* of the electrode formation region can be exclusively reduced by at least 30% so as to be close to the chroma of the non-electrode-formation region. It is therefore possible to sufficiently reduce the difference in chroma between the light emitting part and the non- light-emitting part of the organic EL emission device 10 to obtain uniform chroma in a practical range, and thus configure the organic EL emission device 10 having a good appearance.

When the substrate 11 includes a resin film having the first barrier layer 12 thereon, not only the electrode but also the first barrier layer 12 affects the chroma of the light transmitted by the organic EL emission device 10. Hence, when the substrate 11 includes a resin film, the color adjustment layer 13 is preferably provided not only over the electrode formation region but also over the entire region having the first barrier layer 12. When the substrate 11 includes a resin film, the first barrier layer 12 is preferably provided over the entire area of the substrate 11 in light of reliability of the organic EL emission device 10. Hence, when the substrate 11 includes a resin film, the color adjustment layer 13 shown in Fig. 2 is formed over the entire area of the substrate 11 in a preferable configuration. In such a configuration, the color adjustment layer 13 is preferably used so as to reduce the chroma of each of the electrode formation region and the non-electrode-formation region. In particular, the color adjustment layer 13 is preferably used such that the chroma of the electrode formation region can be reduced by at least 30% while the chroma of the non-electrode-formation region

is reduced. When the color adjustment layer 13 is formed in both the electrode formation region and the non-electrode-formation region, respective color adjustment layers 13 having either the same or different characteristics may be provided in the electrode formation region and the non-electrode-formation region.

On the other hand, when the substrate 11 includes a glass substrate, reliability of the organic EL emission device 10 can be secured even if the first barrier layer 12 is not provided. In such a case, the configuration of the first barrier layer 12 as shown in Fig. 1 can be omitted. That is, no influence occurs on the chroma of the light transmitted by the organic EL emission device 10 due to the first barrier layer 12. Hence, when the substrate 11 includes a glass substrate, the color adjustment layer 13 and the electrode formation region are preferably disposed so as to be in line with each other as in the configuration shown in Fig. 3.

In the organic EL emission device 10, the color adjustment layer 13 is preferably disposed on a more outer side than the first barrier layer 12 in a stacked direction. In other words, the organic EL emission device 10 preferably includes the substrate 11 and the color adjustment layer 13 on a more outer side than the first barrier layer 12 in the stacked direction. Furthermore, the color adjustment layer 13 is preferably disposed on a more outer side than the substrate 11. That is, the organic EL emission device 10 preferably includes the substrate 11 and the color adjustment layer 13 on a more outer side than the first barrier layer 12, and more preferably includes the color adjustment layer 13, the substrate 11, and the first barrier layer 12 stacked in order from the outer side. The outer side mentioned herein refers to an outer side in a stacked direction of the organic EL emission device 10 toward a substrate 11 side or a sealing substrate 16 side centering on the organic EL element 20. Hence, the outer side of the first barrier layer 12 corresponds to a surface opposite to the surface, on which the organic EL element 20 is disposed, of the first barrier layer 12, i.e., refers to the side toward the substrate 11 with respect to the first barrier layer 12 in the stacked direction. The outer side of the substrate 11 corresponds to a surface opposite to the surface, on which the organic EL element 20 is disposed, of the substrate 11, and refers to a surface opposite to the surface, on which the first barrier layer 12 is disposed, of the substrate 11 in the configuration shown in Fig. 1.

In the organic EL emission device 10, any other configuration is not provided between the first barrier layer 12 and the organic EL element 20, which makes it possible to suppress a reduction in emission efficiency or a reduction in performance of the organic EL element 20, such as formation of a dark spot. The color adjustment layer 13 is therefore disposed on a more outer side than the first barrier layer 12, making it possible to improve reliability of the organic EL emission device 10. That is, in light of reliability of the organic EL emission device 10, the substrate 11 and the color adjustment layer 13 are preferably provided on a more outer side than the first barrier layer 12. Furthermore, the color adjustment layer 13 is disposed on a more outer side than the substrate 11, making it possible to more improve reliability of the organic EL emission device 10.

The color adjustment layer 13 may be configured to have a uniform color over the entire area of the organic EL emission device 10 or different colors for respective random regions in a planar direction. For example, it is possible to provide color adjustment layers 13 having different colors between the formation region of the organic EL element 20, the electrode formation region, and other region. Even in such a configuration, the color adjustment layer 13 provided in one of the regions may reduce (bring close to 0, or neutral) the chroma C* given by the Formula (1) of the transmitted light during no light emission of the organic EL emission device 10 compared with the organic EL emission device 10 having the configuration without the color adjustment layer 13. For example, the organic EL emission device 10 preferably includes a first color adjustment layer 13, which reduces the chroma C* by at least 30%, in the electrode formation region, and a second color adjustment layer 13, which reduces the chroma C* at a smaller reduction rate than in the electrode formation region, in another region.

While not shown, the first electrode 21 of the organic EL element 20 includes a portion used for a light emitting portion, and further includes an external connection electrode for power feeding, which is led to the outside of the adhesive layer 14, on the substrate 11. Furthermore, the second electrode 23 includes a portion used for the light emitting portion, and further includes an external connection electrode, which is led to the outside of the adhesive layer 14, on the substrate 11 on a side in a first direction opposite to a second direction in which the first electrode 21 is led. The first electrode 21 and the second electrode 23 are each connected to the external connection electrode provided on the substrate 11 while being isolated from each other by the light emitting unit 22.

The components to configure the organic EL emission device 10 of Fig. 1 are described below in detail. The following description is merely given on exemplary components that can configure the organic EL emission device of this embodiment. Another configuration may also be used.

Color Adjustment Layer

Any configuration can be used as a configuration of the color adjustment layer 13, as long as the configuration can be used in the organic EL emission device 10 to reduce the chroma of the transmitted light during no light emission compared with the organic EL emission device 10 having the configuration without the color adjustment layer 13. For example, the color adjustment layer 13 includes a configuration having a layer containing a fluorescent material or a

light-absorbing dye as a color adjuster, a dielectric thin film layer utilizing optical interference, and the like. A commercially available color filter may be used as the color adjustment layer 13. The layer containing a fluorescent material or a light-absorbing dye or the commercially available color filter preferably has a color in a complementary color relationship with a color of the transmitted light during no light emission of the organic EL emission device 10 having the configuration without the color adjustment layer 13. The complementary color relationship mentioned herein corresponds to a difference in hue angle of 135 to 225 degrees.

When the color adjustment layer 13 has the layer containing the fluorescent material or the light-absorbing dye as the color adjuster, the layer preferably has a configuration where the color adjuster is retained by a binder. For example, such a layer can be formed by a thin film formation method such as a coating process, an inkjet process, or a printing process using a dispersion liquid containing the color adjuster, the binder, and an appropriate solvent.

When the color adjustment layer 13 includes the dielectric thin film layer, the layer preferably includes a multilayer film including a plurality of stacked, dielectric thin films. The multilayer film including the dielectric thin films can be formed by a typical vapor phase growth process. For example, a desired dielectric thin film is formed using a film formation method such as a vacuum evaporation process or a sputtering process, and such film formation is performed multiple times, thereby a multilayer film including stacked dielectric thin films can be formed.

Thickness of the color adjustment layer 13 is not particularly limited as long as the color adjustment layer 13 is formed at a thickness that secures the effect of reducing the chroma of the organic EL emission device 10. In the configuration where the color adjustment layer 13 contains the color adjuster, for example, necessary thickness is determined from the additive amount of the color adjuster required for reducing optical chroma, optical performance of each color adjuster, and the like. When the color adjustment layer 13 includes the dielectric thin film layer, the thickness can be determined from calculated values of thickness of each layer required for reducing the chroma and the number of stacked layers. The thickness of the color adjustment layer 13 can be appropriately set in a range from 10 nm to 300 μm, for example, depending on color adjustment methods.

(Fluorescent Material)

For example, an organic or inorganic fluorescent material can be used as the fluorescent material to constitute the color adjustment layer 13. The fluorescent material is preferably excited by a light having a wavelength of 400 to 450 nm. The excitation wavelength of 400 nm or more allows the effect of reducing the chroma of the organic EL emission device 10 to be sufficiently exhibited. The excitation wavelength of 450 nm or less makes it possible to suppress a reduction in emission efficiency of the organic EL emission device 10 due to coloring of the color adjustment layer 13 caused by visible light absorption, or absorption of visible light emitted from the organic EL element 20 by the color adjustment layer 13.

The organic fluorescent material includes fluorescent dyes of diaminostilbene series, benzidine series, imidazole series, triazole series, imidazolone series, bis (benzoxazolyl)thiophene series, and bis (benzoxazolyl)stilbene series, and a fluorescent dye described in Japanese Unexamined Patent Application Publication No. 2007-264011.

The usable inorganic fluorescent material includes zinc oxide (ZnO), zinc sulfide (ZnS), zinc selenide (ZnSe), cadmium sulfide (CdS), and yttrium aluminum garnet (YAG) containing a rare earth such as $Er^{3+}$, $Yb^{3+}$, $Tm^{3+}$, $Pr^{3+}$, or $Eu^{3+}$.

(Light-Absorbing Dye)

For example, the following red dyes, green dyes, and blue dyes can be used as the light-absorbing dye to constitute the color adjustment layer 13. Such types of light-absorbing dyes may be used independently, or several types of light-absorbing dyes may be mixedly used. Dyes having different colors may be combined to produce any appropriate color.

Examples of the usable red dye include perylene pigments, lake pigments, azo pigments, quinacridone pigments, anthraquinone pigments, anthracene pigments, and isoindoline pigments. Examples of the usable green dye include phthalocyanine pigments such as halogen-polysubstituted phthalocyanine pigments or halogen-polysubstituted copper phthalocyanine pigments, triphenylmethane basic dyes, isoindoline pigments, and isoindolinone pigments. Examples of the usable blue dye include copper phthalocyanine pigments, anthraquinone pigments, indanthrene pigments, indophenol pigments, cyanine pigments, and dioxazine pigments. Such pigments may be used independently, or at least two of the pigments may be mixedly used.

(Binder)

The usable binder to configure the color adjustment layer 13 may include proteins or cellulose derivatives such as gelatin and gelatin derivatives, natural compounds such as starch, gum arabic, and polysaccharides including dextran, pullulan, and carrageenan, synthetic polymer compounds such as polyvinyl alcohol, polyethylene glycol, polyvinyl pyrrolidone, acrylamide polymer and derivatives thereof, and resin materials such as polyolefin resin, polyacrylic resin, polyacrylonitrile resin, polyamide resin, polyester resin, epoxy resin, polycarbonate resin, and fluorine resin. In respect of a ratio of the color adjuster to the binder in the color adjustment layer 13, the contents of the color adjuster and the binder in the color adjustment layer 13 are determined such that the chroma during no light emission of the organic EL emission device 10 is close to 0.

(Dielectric Thin Film Layer)

The dielectric thin film layer preferably includes a dielectric multilayer film formed by stacking layers having different refractive indicia using a high-refractive-index material and a low-refractive-index material. A usable material to constitute the dielectric multilayer film includes $Al_2O_3$ (refractive index 1.6), $CeO_3$ (refractive index 2.2), $Ga_2O_3$ (refractive index 1.5), $HfO_2$ (refractive index 2.0), indium tin oxide (ITO, refractive index 2.1), indium zinc oxide (refractive index 2.1), MgO (refractive index 1.7), $Nb_2O_5$ (refractive index 2.3), $SiO_2$ (refractive index 1.5), $Ta_2O_5$ (refractive index 2.2), $TiO_2$ (refractive index 2.3 to 2.5), $Y_2O_3$ (refractive index 1.9), ZnO (refractive index 2.1), $ZrO_2$ (refractive index 2.1), $AlF_3$ (1.4), $CaF_2$ (1.2 to 1.4), $CeF_3$ (1.6), $GdF_3$ (1.6), $LaF_3$ (1.59), LiF (1.3), $MgF_2$ (1.4), NaF (1.3), and the like.

Substrate

The substrate 11 to configure the organic EL emission device 10 is not limited to a particular type of material, such as glass and plastic. The substrate 11 may include glass, quartz, a transparent resin film, and the like.

Examples of the glass include silica glass, soda lime glass, lead glass, borosilicate glass, and alkali-free glass. In light of adherence with an adjacent layer, durability, and smoothness, surfaces of such glass materials are each subjected to physical treatment such as polishing, or coated with a film including an inorganic or organic matter, or coated with a hybrid film as a combination of the inorganic and organic films as necessary.

Examples of the resin film include films of polyester resin such as polyethylene terephthalate (PET), polyethylene naphthalate (PEN), and modified polyester, polyolefin resin such as polyethylene (PE) resin, polypropylene (PP) resin, polystyrene resin and cyclic olefin resin, vinyl resin such as polyvinyl chloride and polyvinylidene chloride, polyether ether ketone (PEEK) resin, polysulfone (PSF) resin, polyether sulfone (PES) resin, polycarbonate (PC) resin, polyamide resin, polyimide resin, acrylic resin, and triacetyl cellulose (TAC) resin. Such resins may be used independently or in combination. The substrate 11 may be either a non-stretched or a stretched film.

Barrier Layer

A known layer configuration can be used without limitation for the first barrier layer 12 and the second barrier layer 15 as long as the layer has a gas barrier property of suppressing infiltration of water or oxygen causing deterioration of the organic EL element 20. A gas barrier property required for the organic EL emission device 10 preferably includes, for example, a property of a gas barrier film (gas barrier film or the like) that has a water vapor transmission rate, determined by a method based on JIS K 7129-1992 (25 $\pm$ 0.5°C, relative humidity 90 $\pm$ 2%), of 0.01 g / ($m^2$•24 h) or less. Furthermore, the barrier layer preferably has an oxygen transmission rate, determined by a method based on JIS K 7126-1987, of $1 \times 10^{-3}$ ml / ($m^2$•24 h•atm) or less and the water vapor transmission rate of $1 \times 10^{-5}$ g / ($m^2$•24 h) or less. The first barrier layer 12 and the second barrier layer 15 may each be formed of a single layer or be a stack including a plurality of layers.

Each of the first barrier layer 12 and the second barrier layer 15 to configure the organic EL emission device 10 is not particularly limited, and may be a barrier layer formed by vapor phase deposition of an inorganic compound or a barrier layer formed by coating. If the first barrier layer 12 and the second barrier layer 15 are each a single layer, the layer may be a film including an evaporated barrier layer, or a film including a silicon-containing layer formed by coating and drying of a liquid composition containing a silicon-containing compound. Furthermore, the first barrier layer 12 and the second barrier layer 15 may each be finally configured by a plurality of layers. When the barrier layer is configured by a plurality of layers, the barrier layer may be formed by evaporation or by coating and drying, or may have a stack configuration of such two types of barrier layers.

(Coating Method: Silicon-Containing Layer)

The first barrier layer 12 and the second barrier layer 15 each preferably have the silicon-containing layer formed by applying and drying a liquid composition containing a silicon-containing compound. In particular, the layer preferably has a polysilazane-modified layer as the silicon-containing layer. The organic EL emission device 10 can secure high barrier performance by including the silicon-containing layer or the polysilazane-modified layer as each of the first barrier layer 12 and the second barrier layer 15. The polysilazane-modified layer at least partially has a polysilazane-modified portion including a polysilazane compound modified by an energy beam such as an excimer light. Typically, the polysilazane-modified portion is formed on a surface of a layer irradiated with the energy beam.

Examples of the silicon-containing compound to form the silicon-containing layer may include polysiloxane, polysilsesquioxane, polysilazane, polysiloxazane, polysilane, and polycarbosilane. Among them, the silicon-containing compound preferably has at least one bond selected from a group including a silicon-nitrogen bond, a silicon-hydrogen bond, and a silicon-silicon bond.

A more preferable, usable silicon-containing compound includes polysilazane having a silicon-nitrogen bond and a silicon-hydrogen bond, polysiloxazane having a silicon-nitrogen bond, polysiloxane having a silicon-hydrogen bond, polysilsesquioxane having a silicon-hydrogen bond, and polysilane having a silicon-silicon bond. Among them, a silicon-containing compound having one of a silicon-nitrogen bond, a silicon-hydrogen bond, and a silicon-silicon bond is preferably used.

The silicon-containing layer is formed by applying and drying a liquid composition containing a silicon-containing compound, and has a special composition to exhibit a gas barrier property. Such a silicon-containing layer is substantially free from contamination of a foreign substance such as a particle during film formation unlike formation by a vapor phase deposition process,

Any solvent that dissolves the silicon-containing compound may be used without limitation for preparing the liquid composition (silicon-containing liquid composition) to form the silicon-containing layer. The solvent is preferably an organic solvent that does not include water and a reactive group (for example, a hydroxyl group or amine group), which may easily react with the silicon-containing compound, and is inactive against the silicon-containing compound. An aprotic organic solvent is more preferable. Specifically, the usable solvent includes the aprotic organic solvent including, for example, hydrocarbon solvents including aliphatic hydrocarbons such as pentane, hexane, cyclohexane, toluene, xylene, Solvesso, and turpentine, alicyclic hydrocarbons, and aromatic hydrocarbons; halogen hydrocarbon solvents such as methylene chloride and trichloroethane; esters such as ethyl acetate and butyl acetate; ketones such as acetone and methyl ethyl ketone; and ethers including aliphatic ethers such as dibutyl ether, dioxane, and tetrahydrofuran, and alicyclic ethers, for example, tetrahydrofuran, dibutyl ether, mono- and poly-alkylene glycol dialkyl ether (diglymes). An appropriate solvent is selected from the solvents according to the intended use, such as solubility of polysilazane or an evaporation rate of the solvent. The solvents may be used independently, or at least two of the solvents may be mixedly used.

Although a coating film containing the silicon-containing compound can be applied to the barrier layer as the silicon-containing layer without any treatment, the silicon-containing layer is preferably subjected to a shift reaction (modification). The silicon-containing layer can be subjected to ultraviolet irradiation, plasma irradiation, and heating treatment as the shift reaction. In particular, the silicon-containing layer is preferably irradiated with vacuum ultraviolet rays for the shift reaction (modification). Specifically, the silicon-containing layer containing polysilazane is preferably irradiated with vacuum ultraviolet rays to form a polysilazane-modified layer. Any vacuum ultraviolet light source may be used as long as the light source generates a light having a wavelength of 100 to 180 nm. Preferably, the vacuum ultraviolet light source includes an excimer radiator with a maximum radiation at about 172 nm (for example, Xe excimer lamp), a low-pressure mercury-vapor lamp having an emission line at about 185 nm, a medium or high-pressure mercury-vapor lamp having a wavelength component of 230 nm or less, and an excimer lamp with a maximum radiation at about 222 nm.

(Vapor Phase Deposition)

Any appropriate deposition process can be used without limitation as a vapor phase deposition process to form the vapor-phase-deposited barrier layer. Examples of such a process include a vacuum evaporation process, a reactive evaporation process, a sputtering process, a reactive sputtering process, a molecular epitaxy process, a cluster ion beam process, an ion plating process, a plasma polymerization process, an atmospheric-pressure plasma polymerization process, a plasma CVD process, a laser CVD process, a thermal CVD process, and a coating process. The atmospheric-pressure plasma polymerization process described in Japanese Unexamined Patent Application Publication No. 2004-68143 is particularly preferably used for formation of the barrier layer.

In the vapor phase deposition, examples of a constituent material of the first barrier layer 12 and the second barrier layer 15 include inorganic materials such as silicon oxide, silicon nitride, silicon oxynitride, aluminum oxide, and zirconium oxide. The first barrier layer 12 and the second barrier layer 15 may each be formed of an organic coating film or a hybrid coating film of inorganic and organic matters. A configuration including a stacked structure of an inorganic material layer and an organic material layer may also be preferably used in order to reduce fragility of each of the first barrier layer 12 and the second barrier layer 15. Although a stacked order of the inorganic layer and the organic layer is not particularly limited, both layers are preferably alternately stacked several times.

First Electrode and Second Electrode

The first electrode 21 and the second electrode 23 each include a layer containing a conducive material for electric conduction in the organic EL emission device 10. Furthermore, the first electrode 21 and the second electrode 23 may each have a stacked structure as necessary.

For example, the first electrode 21 and the second electrode 23 each include a thin film of a metal such as Au, Ag, Pt, Cu, Rh, Pd, Al, or Cr, a metal oxide such as $In_2O_3$, CdO, $CdIn_2O_4$, $Cd_2SnO_4$, $TiO_2$, $SnO_2$, ZnO, indium tin oxide (ITO), indium zinc oxide (IZO), IGO, IWZO, GZO, IGZO, ZTO, ZnO, $TiO_x$, $VO_x$, $CuAlO_2$, $CuGaO_2$, $SrCu_2O_2$, or RuO, and an inorganic compound such as TiN, ZrN, HfN, CuI, InN, GaN, or $LaB_6$. The first electrode 21 and the second electrode 23 may each include only one or at least two of such conductive materials. In the organic EL emission device 10, in light of transparency and conductivity, the first electrode 21 preferably includes the above-described metal oxide, in particular, at least one metal oxide selected from ITO, IZO, IGO, IWZO, GZO, IGZO, ZnO, and ZTO.

When the metal oxide or the inorganic compound is used for the first electrode 21 and the second electrode 23, each electrode is preferably formed at a thickness of 10 to 500 nm, more preferably 100 to 300 nm, depending on volume resistance of the material to be used. The thickness of less than 10 nm is insufficient for the metal oxide or the inorganic compound to form a continuous film, and thus desired conductivity is not exhibited. The thickness of more than 500 nm may induce a crack due to bending.

A metal thin film mainly containing silver is preferably used for the second electrode 23. The metal mainly containing silver means that a content ratio of silver is 60 at% (atomic percent) or more. In light of conductivity, the content ratio of silver is preferably 90 at% or more, more preferably 95 at% or more. Most preferably, the second electrode 23 is made of single silver.

A metal to be combined with silver includes zinc, gold, copper, palladium, aluminum, manganese, bismuth, neodymium, and molybdenum. For example, a combination of silver and zinc improves sulfurization resistance of the metal thin film mainly containing silver. A combination of silver and gold improves salt (NaCl) resistance of the metal thin film mainly containing silver. A combination of silver and copper improves oxidation resistance of the metal thin film mainly containing silver.

When the metal thin film is used for each of the first electrode 21 and the second electrode 23, thickness of the metal thin film is preferably 20 nm or less, more preferably within a range from 5 to 15 nm. The thickness of the metal thin film is adjusted to 20 nm or less, thereby reflection by the metal thin film is less likely to occur. Furthermore, when the thickness of the metal thin film is 20 nm or less, optical admittance is easily adjusted by an optical adjustment layer, so that light reflection is easily suppressed. The thickness of the metal thin film can be determined by a measurement using an ellipsometer.

The first electrode 21 and the second electrode 23 are produced by any appropriate method without limitation. The first electrode 21 and the second electrode 23 each preferably include a layer formed by a vacuum evaporation process. The vacuum evaporation process can produce the first and second electrodes 21 and 23 having high flatness at an extremely high speed while the substrate 11 is not exposed to a high-temperature atmosphere. A known evaporation process such as a resistance heating evaporation process, an electron beam evaporation process, an ion plating process, and an ion beam evaporation process can be appropriately used as the evaporation process usable for production of the first electrode 21 and the second electrode 23. A known sputter process can be appropriately used as the sputter process usable for production of the first electrode 21 and the second electrode 23, including a diode sputter process, a magnetron sputter process, a DC sputter process, a DC pulse sputter process, a radio frequency (RF) sputter process, a dual magnetron sputter process, a reactive sputter process, an ion beam sputter process, a bias sputter process, and a facing target sputter process.

(External Connection Electrode)

The organic EL emission device 10 may have an external connection electrode for power feeding in addition to the first electrode 21 and the second electrode 23 used for the emission portion, such as a lead electrode of the first electrode 21 or a lead electrode of the second electrode 23 in order to lead the first electrode 21 and the second electrode 23 to the outside of the sealing component. In particular, when the metal thin film is used for each of the first electrode 21 and the second electrode 23, the external connection electrode is preferably used.

A conductive material can be appropriately used for the external connection electrode. Examples of the conductive material include a thin film of a metal such as Au, Ag, Pt, Cu, Rh, Pd, Al, or Cr, a metal oxide such as $In_2O_3$, CdO, $CdIn_2O_4$, $Cd_2SnO_4$, $TiO_2$, $SnO_2$, ZnO, indium tin oxide (ITO), indium zinc oxide (IZO), IGO, IWZO, GZO, IGZO, ZTO, ZnO, $TiO_x$, $VO_x$, $CuAlO_2$, $CuGaO_2$, $SrCu_2O_2$, or RuO, and an inorganic compound such as TiN, ZrN, HfN, CuI, InN, GaN, or $LaB_6$. Furthermore, a material such as Pt, Pd, and Mo, or a conductive metal oxide is preferably used in light of moisture resistance. For example, when a metal material is used for the external connection electrode, a stack of an Al layer and a Mo layer is preferably used. The conductive metal oxide is more preferably used in light of transparency.

The external connection electrode is also preferable to have a transparency similar to that of each of the first electrode 21 and the second electrode 23.

Light Emitting Unit

The light emitting unit 22 is an emitter including a light emitting layer containing at least an organic compound. Further, the light emitting unit 22 mainly includes organic functional layers such as a hole transport layer and an electron transport layer in addition to the light emitting layer. The light emitting unit 22 is held between a pair of electrodes including the first electrode 21 and the second electrode 23, and emits light through recombination of holes and electrons, which are supplied from the respective electrodes, in the light emitting layer. The organic EL element 20 may have a plurality of such light emitting units depending on desired emission colors.

In the organic EL element 20, the light emitting unit 22 may have a typical layer structure without limitation. For example, when the first electrode 21 serves as an anode and the second electrode 23 serves as a cathode, the light emitting unit 22 may have an exemplary configuration, in which a hole injection layer, a hole transport layer, a light emitting layer, an electron transport layer, and an electron injection layer are stacked in order from a first electrode 21 side. The hole injection layer and the hole transport layer may be integrally provided as a hole transport injection layer. Similarly, the electron transport layer and the electron injection layer may be integrally provided as an electron transport injection layer. The light emitting unit 22 may have a layer made of an inorganic material. For example, the electron injection layer may be made of an inorganic material.

In the light emitting unit 22, a hole stopping layer, an electron stopping layer, or the like may be stacked at a necessary position in addition to such layers. Furthermore, the light emitting layer may be structured to include various-color light emitting layers that generate emission light in various wavelength regions and are stacked with a non-light-emitting auxiliary layer therebetween. The auxiliary layer may serve as the hole stopping layer or the electron stopping layer.

The organic EL element 20 may have a so-called tandem structure, in which a plurality of light emitting units 22, each including at least one light emitting layer, are stacked. In a typical element configuration of the tandem structure, for example, an anode, a first light emitting unit, an intermediate connector layer, a second light emitting unit, an intermediate connector layer, a third light emitting unit, and a cathode are provided in this order.

The first light emitting unit, the second light emitting unit, and the third light emitting unit may have the same configuration or different configurations from one another. In addition, any two of the light emitting units may have the same configuration while the other has a different configuration. The plurality of light emitting units 22 may be directly stacked or may be stacked with an intermediate connector layer therebetween.

The intermediate connector layer may be usually called an intermediate electrode, an intermediate conductive layer, a charge generation layer, an electron extraction layer, a connection layer, or an intermediate insulating layer, and may include a known material and a known configuration as long as the layer supplies electrons to an adjacent layer on an anode side and supplies holes to an adjacent layer on a cathode side.

Specific examples of the tandem organic EL element may include element configurations and constitutional materials described in, for example, U.S. Patent Nos. 6337492, 7420203, 7473923, 6872472, 6107734, and 6337492; International Publication WO 2005/009087; Japanese Unexamined Patent Application Publication Nos. 2006-228712, 2006-24791, 2006-49393, 2006-49394, 2006-49396, 2011-96679, and 2005-340187; Japanese Patent Nos. 4711424, 3496681, 3884564, and 4213169; Japanese Unexamined Patent Application Publication Nos. 2010-192719, 2009-076929, 2008-078414, 2007-059848, 2003-272860, and 2003-045676, and International Publication WO 2005/094130.

Adhesive Layer

The adhesive layer 14 fixes the sealing substrate 16 having the second barrier layer 15 to a substrate 11 side while being used as a sealing agent to seal the organic EL element 20. In the organic EL emission device 10, the adhesive layer 14 is preferably transparent like the substrate 11 or the sealing substrate 16.

A known resin used for sealing of the organic EL element can be used for the adhesive layer 14. Examples of the usable resin include a photo-curing or thermosetting adhesive having a reactive vinyl group of an acrylate oligomer or a methacrylate oligomer, and a moisture curing adhesive of 2-cyanoacylic acid ester or the like. In addition, thermosetting or chemical curing (two-part) adhesive such as an epoxy adhesive can be used for the adhesive layer 14. A hot-melt adhesive of polyamide, polyester, or polyolefin may also be used. A cation-curing-type ultraviolet cure epoxy resin adhesive may also be used.

The adhesive layer 14 may be applied by printing using a commercially available dispenser onto the sealing substrate 16 in the same manner as screen printing. The organic material to constitute the light emitting unit 22 of the organic EL element 20 may be thermally deteriorated. Hence, the adhesive layer 14 is preferably adherable and curable

at a temperature from room temperature (25°C) to 80°C. A desiccant may be dispersed in the adhesive layer 14.

Sealing Substrate

The sealing substrate 16 is a component that covers the organic EL element 20 from the upper side in the organic EL emission device 10 while being fixed to the substrate 11 and to the organic EL element 20 with the adhesive layer 14. The sealing substrate 16 may have a film shape or a sheet shape. The sealing substrate 16 may have the same configuration as that of the substrate 11.

Other Components

(Protective Layer)

When the electrode includes a metal thin film of silver or the like, a protective layer, which can suppress reflection of the metal thin film, surface plasmon resonance, and the like, is preferably provided at a position so as to be in contact with the metal thin film. A material of the protective layer includes an organic compound having a sulfur atom (sulfur-containing compound) and an organic compound having a nitrogen atom (nitrogen-containing compound), the light transmittance of each of which is less likely to change even after storage. A specific example of the nitrogen-containing compound usable for the protective layer may include a nitrogen-containing compound described in Japanese Unexamined Patent Application Publication No. 2015-060728, for example. A specific example of the sulfur-containing compound usable for the protective layer may include a sulfur-containing compound described in Japanese Unexamined Patent Application Publication No. 2015-060728, for example.

(Optical Adjustment Layer)

The organic EL emission device 10 preferably includes an optical adjustment layer to extract light emission from the organic EL element 20 to the outside and increase transparency of the organic EL emission device 10.

For example, the optical adjustment layer is disposed on the second electrode 23 at a position so as to be in contact with the second electrode 23, making it possible to suppress reflection at a stacked interface of the second electrode 23 formed by a metal material or the like, and suppress absorption and interference by the second electrode 23, and thus improve extraction efficiency of emitted light from a second electrode 23 side. The optical adjustment layer is disposed on the second electrode 23, making it possible to suppress a reduction in light transmittance or coloring of light transmitted by the organic EL emission device 10 due to absorption or interference by the second electrode 23, and improve transparency of the organic EL emission device 10.

The optical adjustment layer preferably has a lower refractive index in terms of increasing light transmittance. The refractive index of the optical adjustment layer is preferably 1.7 or less, more preferably 1.6 or less, and most preferably 1.4 or less. The refractive index is assumed to be a value at a wavelength of 550 nm measured under an atmosphere of 25°C. The refractive index can be obtained through measurement using a commercially available ellipsometer. Any existing compound can be used as a constituent material of the optical adjustment layer as long as the compound secures an appropriate refractive index that meets the above-described refractive index relationship. Examples of a material to constitute the optical adjustment layer include $Al_2O_3$ (refractive index 1.6), $Ga_2O_3$ (refractive index 1.5), $SiO_2$ (refractive index 1.5), $AlF_3$ (1.4), $CaF_2$ (1.2 to 1.4), $CeF_3$ (1.6), $GdF_3$ (1.6), $LaF_3$ (1.59), LiF (1.3), $MgF_2$ (1.4), MgO (refractive index 1.7), and NaF (1.3).

(Sealing Layer)

The organic EL emission device 10 preferably has a sealing layer covering the side surfaces and the upper surface of the organic EL element 20 to prevent infiltration of water vapor into the organic EL element 20. The sealing layer is preferably made of transparent and insulative material. The constituent material of the sealing layer preferably includes an inorganic compound capable of suppressing entering of, for example, water and oxygen that cause deterioration of the organic EL element 20. Any appropriate material such as, for example, silicon oxide, silicon nitride, silicon oxynitride, aluminum oxide, and zirconium oxide can be used as the inorganic compound to constitute the sealing layer. The sealing layer preferably has gas barrier properties, insulation properties, and transparency. Specifically, the sealing layer preferably has a water vapor transmission rate of about 0.01 g / ($m^2$•day•atm) or less, more preferably about 0.0001 g / ($m^2$•day•atm) or less, a resistivity of $1 \times 10^{12}$ $\Omega \cdot$ cm or more, and a light transmittance of 80% or more in a visible light region.

Examples of usable methods of forming the sealing layer include a vacuum evaporation process, a sputter process, a magnetron sputter process, a molecular epitaxy process, a cluster ion beam process, an ion plating process,

a plasma polymerization process, an atmospheric-pressure plasma polymerization process, a plasma CVD process, a laser CVD process, and a thermal CVD process.

(Antistatic Layer)

The organic EL emission device 10 may have an antistatic layer on a surface (back surface), on which the organic EL element 20 is not provided, of the substrate 11. The antistatic layer is preferably disposed in the outermost layer on the back side of the substrate 11. The antistatic layer makes it possible to suppress sticking and the like of the substrate 11 or the sealing substrate 16 when the organic EL emission device 10 is stacked or when a long substrate 11 is wound in a roll.
In the organic EL emission device 10, the antistatic layer is constituted of particles and a binder resin. The antistatic layer preferably contains the particles within a range from 1 to 900 mass parts with respect to 100 mass parts of the binder resin. The particles to constitute the antistatic layer are preferably inorganic fine particles, inorganic oxide particles, conductive polymer particles, conductive carbon fine particles, and the like. In particular, metal oxide particles such as ZnO, $TiO_2$, $SnO_2$, $Al_2O_3$, $In_2O_3$, MgO, BaO, $MoO_2$, and $V_2O_5$, and the inorganic oxide particles such as $SiO_2$ are preferable. $SnO_2$ and $SiO_2$ are particularly preferable.
Examples of the usable binder resin to constitute the antistatic layer include cellulose derivatives such as cellulose diacetate, cellulose triacetate, cellulose acetate butyrate, cellulose acetate phthalate, and cellulose nitrate; polyester such as polyvinyl acetate, polystyrene, polycarbonate, polybutylene terephthalate, and co-polybutylene tereisophthalate; polyvinyl alcohol derivatives such as polyvinyl alcohol, polyvinyl formal, polyvinyl acetal, polyvinyl butyral, and polyvinyl benzal; norbornene resins each containing a norbornene compound; acrylic resins such as polymethyl methacrylate, polyethyl methacrylate, polypropylmethyl methacrylate, polybutyl methacrylate, and polymethyl acrylate; and copolymers of the acrylic resins and other resins, while such exemplified resin materials are not limitative. Among such resin materials, the cellulose derivatives or the acrylic resins are preferably used, and the acrylic resins are most preferable.
In the binder resins, a thermoplastic resin having a weight-average molecular weight of 400,000 or more and a glass transition temperature within a range from 80 to 110°C is preferable in terms of optical properties and quality of the antistatic layer. The glass transition temperature can be obtained by a method stipulated in JIS K 7121. The binder resin in the particle-containing layer preferably contains a thermosetting resin in a ratio of at least 60 mass%, more preferably at least 80 mass%, of the total resin. In addition, an actinic-ray-curing resin, a thermosetting resin, and the like can also be used as necessary.

2. Embodiment of Transparent Organic Electro-Luminescence Emission Device (Second Embodiment)

A second embodiment of the organic EL emission device is now described. Fig. 4 shows a configuration of the organic EL emission device of the second embodiment. In the organic EL emission device 10 of Fig. 4, the color adjustment layer 13 is disposed on the outer side of the sealing substrate 16. That is, the color adjustment layer 13 is disposed on a surface opposite to the surface, on which the organic EL element 20 is disposed, of the sealing substrate 16. The organic EL emission device 10 of Fig. 4 has the same configuration as that of the first embodiment (see Fig. 1) except for the position at which the color adjustment layer 13 is disposed. The following description is therefore given only on the configuration involving the color adjustment layer 13 while omitting the configurations similar to those of the first embodiment.
The organic EL emission device 10 is not limited to the configuration where the color adjustment layer 13 is disposed on the side toward the substrate 11 with respect to the organic EL element 20 as in the first embodiment, and the color adjustment layer 13 may be disposed at any position other than between the layers of the organic EL element 20. For example, as shown in Fig. 4, the color adjustment layer 13 may be provided on the outer side of the sealing substrate 16. The color adjustment layer 13 may be provided not only on the outer side of the sealing substrate 16 as shown in Fig. 4, but also at one or more position of between the second electrode and the adhesive layer 14, between the adhesive layer 14 and the second barrier layer 15, and between the second barrier layer 15 and the sealing substrate 16.
In particular, in the organic EL emission device 10, when the color adjustment layer 13 is disposed on the side toward the sealing substrate 16 with respect to the organic EL element 20, the color adjustment layer 13 is preferably disposed on a more outer side than the second barrier layer 15. Furthermore, as shown in Fig. 4, the color adjustment layer 13 is preferably disposed on a more outer side than the sealing substrate 16. The outer side of the second barrier layer 15 refers to a surface opposite to the surface, on which the organic EL element 20 is disposed, of the second barrier layer 15, or the side toward the sealing substrate 16 with respect to the second barrier layer 15 in the stacked direction. The outer side of the sealing substrate 16 refers to a surface opposite to the surface, on which the organic EL element 20 is disposed, of the sealing substrate 16 in the stacked direction, i.e., a surface opposite to the surface, on

which the second barrier layer 15 is disposed, of the sealing substrate 16 in the configuration shown in Fig. 4.

That is, the organic EL emission device 10 having a configuration, in which the color adjustment layer 13 is disposed on the side toward the sealing substrate 16 with respect to the organic EL element 20, preferably includes the sealing substrate 16 and the color adjustment layer 13 on a more outer side than the second barrier layer 15. Furthermore, such an organic EL emission device 10 preferably includes the color adjustment layer 13 on a more outer side than the sealing substrate 16. In the organic EL emission device 10, therefore, the color adjustment layer 13, the sealing substrate 16, and the second barrier layer 15 are preferably stacked in this order from the outside.

The color adjustment layer 13 is disposed on a more outer side than the second barrier layer 15, making it possible to suppress a reduction in performance of the organic EL element 20, such as a reduction in emission efficiency and occurrence of a dark spot due to the color adjustment layer 13, and thus improve reliability of the organic EL emission device 10. Furthermore, the color adjustment layer 13 is disposed on a more outer side than the sealing substrate 16, which further improves reliability of the organic EL emission device 10.

In the organic EL emission device 10 having a configuration where the color adjustment layer 13 is disposed on the side toward the sealing substrate 16 with respect to the organic EL element 20 as shown in Fig. 4, the color adjustment layer 13 is also preferably formed in a region covering the entire electrode formation region as in Figs. 2 and 3. Furthermore, as shown in Fig. 3, the amount of misregistration between the formation region of the color adjustment layer 13 and the electrode formation region is preferably equal to or within $\pm 5\%$ in planar arrangement. In the configuration where the color adjustment layer 13 is disposed on the sealing substrate 16 side, the above-described arrangement makes it possible to sufficiently reduce the difference in chroma between the electrode formation region and the other region to the extent that visibility is reduced so that the organic EL emission device 10 having a good appearance can be configured.

3. Embodiment of Transparent Organic Electro-Luminescence Emission Device (Third Embodiment)

A third embodiment of the organic EL emission device is now described. Fig. 5 shows a configuration of the organic EL emission device of the third embodiment. In the organic EL emission device 10 of Fig. 5, an ultraviolet absorption layer 17 is provided on the outer side of the substrate 11, and the color adjustment layer 13 is provided on the outer side of the ultraviolet absorption layer 17. The organic EL emission device 10 of Fig. 5 has the same configuration as that of the first embodiment (see Fig. 1) except that the ultraviolet absorption layer 17 is provided. The following description is therefore given only on the configuration involving the ultraviolet absorption layer 17 while omitting the configurations similar to those of the first embodiment.

The organic EL emission device 10 of Fig. 5 includes the ultraviolet absorption layer 17 and the color adjustment layer 13 on a more outer side than the substrate 11. The organic EL emission device 10 includes the ultraviolet absorption layer 17, making it possible to suppress damage of the organic EL element 20 due to ultraviolet rays contained in natural light such as sunlight. In particular, this makes it possible to suppress damage due to denaturation of the organic material to constitute the light emitting unit 22. Hence, the ultraviolet absorption layer 17 is disposed on a natural light incident side on a more outer side than the organic EL element 20, making it possible to suppress a reduction in performance of the organic EL element 20, such as a reduction in emission efficiency and occurrence of a dark spot, and thus improve reliability of the organic EL emission device 10. The ultraviolet absorption layer 17 may be provided at any position other than between the layers of the organic EL element 20, and is preferably provided over the entire area on the outer side of the substrate 11.

In some configurations of the organic EL emission device 10, a resin material or an organic material is used for the substrate 11, the adhesive layer 14, the sealing substrate 16, or the like. In such a configuration, breakage, deformation, discoloration, or the like may also be caused by ultraviolet rays or the like. The ultraviolet absorption layer 17 is therefore preferably disposed on a more outer side on the natural light incident side than the substrate 11 and the sealing substrate 16.

In light of reliability of the organic EL emission device 10, therefore, the ultraviolet absorption layer 17 and the color adjustment layer 13 are stacked on the outer side of the substrate 11 or the sealing substrate 16 in a preferable configuration. In a particularly preferable configuration, the ultraviolet absorption layer 17 and the color adjustment layer 13 are stacked on the outer side of the substrate 11, and the ultraviolet absorption layer 17 and the color adjustment layer 13 are also stacked on the outer side of the sealing substrate 16. When the color adjustment layer 13 is disposed on a more inner side than the substrate 11, only the ultraviolet absorption layer 17 may be disposed on the outer side of the substrate 11. Both the color adjustment layer 13 and the ultraviolet absorption layer 17 may not be disposed on one surface side of the organic EL emission device 10. Instead, one of the color adjustment layer 13 and the ultraviolet absorption layer 17 may be disposed on a substrate 11 side while the other is disposed on a sealing substrate 16 side.

In a configuration where both the color adjustment layer 13 and the ultraviolet absorption layer 17 are disposed on one surface side of the organic EL emission device 10, the stacking order of the color adjustment layer 13 and the ultraviolet absorption layer 17 is not limited. However, when the color adjustment layer 13 contains a fluorescent material

as a color adjuster, the color adjustment layer 13 is preferably provided on a more outer side than the ultraviolet absorption layer 17. The fluorescent material contained in the color adjustment layer 13 requires a short-wavelength light to emit fluorescent light. Hence, if the ultraviolet absorption layer 17 is disposed on the incident side of natural light, the color adjustment layer 13 insufficiently emits fluorescent light, and thus adjustment of the chroma of the organic EL emission device 10 tends to be difficult.

When the color adjustment layer 13 does not contain the fluorescent material as the color adjuster, the ultraviolet absorption layer 17 is preferably disposed on the natural light incident side. This configuration makes it possible to suppress deterioration of the color adjustment layer 13 due to ultraviolet rays, and thus suppress variations in chroma of the organic EL emission device 10 even in long-term use.

The ultraviolet absorption layer 17 can be disposed not only on the substrate 11 side but also on the sealing substrate 16 side of the organic EL emission device 10. The ultraviolet absorption layer 17 is preferably disposed on the surface on the side, on which a relatively large quantity of ultraviolet rays is incident, during practice of the organic EL emission device 10. Hence, the ultraviolet absorption layer 17 may be disposed on the substrate 11 side or the sealing substrate 16 side of the organic EL emission device 10. Furthermore, the ultraviolet absorption layer 17 may be disposed on both the outer side of the substrate 11 and the outer side of the sealing substrate 16 to further improve reliability of the organic EL emission device 10.

Ultraviolet Absorption Layer

The ultraviolet absorption layer 17 contains an ultraviolet absorbent. In addition, the ultraviolet absorption layer 17 preferably contains a resin material as a binder of the ultraviolet absorbent. The ultraviolet absorption layer 17 preferably contains 0.05 to 15 mass percent, more preferably 1 to 10 mass percent, of the ultraviolet absorbent. The ultraviolet absorption layer 17 preferably has a thickness of 1 μm to 30 μm. The thickness of 1 μm or more makes it possible to improve film formability of the ultraviolet absorption layer 17, and easily add ultraviolet absorption capacity, which is required for the ultraviolet absorption layer 17, to the ultraviolet absorption layer 17. Furthermore, the thickness of 30 μm or less makes it easy to produce the ultraviolet absorption layer 17.

The ultraviolet absorbent may be an inorganic or an organic ultraviolet absorbent without limitation, and a known ultraviolet absorbent can be appropriately used. The same binder as in the color adjustment layer 13 can be used. Examples of the usable inorganic ultraviolet absorbent include zinc oxide and titanium oxide. Examples of the usable organic ultraviolet absorbent include benzophenone compounds such as 2,4-dihydroxi-benzophenone and 2-hydroxi-4-methoxy-benzophenone, benzotriazole compounds such as 2-(2'-hydroxy-5-methylphenyl)benzotriazole and 2-(2'-hydroxy-3',5'-di-t-butylphenyl)benzotriazole, phenyl salicylate compounds such as phenyl salicylate and 2-4-di-t-butylphenyl-3,5-di-t-butyl-4-hydroxybenzoate, hindered amine compounds such as bis(2,2,6,6-tetramethylpiperidine-4-yl)sebacate, and triazine compounds such as 2,4-diphenyl-6-(2-hydroxy-4-methoxyphenyl)-1,3,5-triazine, and 2,4-diphenyl-6-(2-hydroxy-4-ethoxyphenyl)-1,3,5-triazine. In particular, the ultraviolet absorbent preferably includes at least one selected from the benzotriazole compounds, the triazine compounds, and the benzophenone compounds.

In addition, the usable ultraviolet absorbent includes a compound having a function of converting energy of ultraviolet rays into vibration energy in molecules and emitting the vibration energy in a form of thermal energy or the like.

Such ultraviolet absorbents may be used independently, or at least two of the ultraviolet absorbents may be mixedly used. Either a synthetic or a commercial product may be used as the ultraviolet absorbent. Examples of the usable commercial product include Tinuvin (registered trademark) 320, Tinuvin (registered trademark) 328, Tinuvin (registered trademark) 234, Tinuvin (registered trademark) 477, Tinuvin (registered trademark) 1577, and Tinuvin (registered trademark) 622 (from BASF Japan Ltd.); ADK STAB (registered trademark) LA-31 (from ADEKA Corporation) and; SEESORB (registered trademark) 102, and SEESORB (registered trademark) 103, and SEESORB (registered trademark) 501 (from SHIPRO KASEI KAISHA, LTD.).

First Example

The present invention is now specifically, but not limitedly, described with examples. A symbol"%" used in the examples refers to "mass%" unless appeal is made.

Production of Organic EL Emission Device of Sample 101

Substrate Preparation

Alkali-free glass from Corning Incorporated, EAGLE XG, 0.7 mm thick was cut into 120 × 100 mm and provided as a substrate.

Production of Organic EL Element

An organic EL element was produced on the substrate in the following manner.

First, a target of $In_2O_3$·ZnO ($In_2O_3$ : ZnO = 90 wt% : 10 wt%) was attached in a commercially available sputter apparatus, and an IZO film was formed on the substrate under the following condition to form a first electrode (anode).

Total pressure: 0.4 MPa
Argon flow rate: 99 sccm
Oxygen flow rate: 1 sccm
Output: 5 W/cm$^2$

Subsequently, each evaporation crucible in a vacuum evaporation apparatus was filled with a material of a corresponding layer to configure a light emitting unit in the optimum amount for element production. A crucible made of a resistance heating material, molybdenum or tungsten, was used as the evaporation crucible.

The vacuum evaporation apparatus was vacuumed to a degree of vacuum $1 \times 10^{-4}$ Pa, and then the evaporation crucible filled with a compound M-2 was energized and heated so that the compound M-2 was evaporated on the electrode (anode) at a deposition rate of 0.1 nm/sec to form a hole injection transport layer 150 nm in thickness.

Subsequently, a compound BD-1 and a compound H-1 were co-evaporated at a deposition rate of 0.1 nm/sec such that the compound BD-1 had a concentration of 5%, resulting in formation of a fluorescent emission layer 30 nm thick that emits blue light.

Subsequently, a compound GD-1, a compound RD-1, and a compound H-2 were co-evaporated at a deposition rate of 0.1 nm/sec such that the compounds GD-1 and RD-1 had concentrations of 17% and 0.8%, respectively, resulting in formation of a phosphorescent emission layer 30 nm thick that emits yellow light.

Subsequently, a compound E-1 was evaporated at a deposition rate of 0.1 nm/sec to form an electron transport layer 80 nm thick.

Furthermore, a LiF film was formed to a thickness of 1.5 nm, and then aluminum was evaporated to a thickness of 1 nm.

Subsequently, silver was evaporated to a thickness of 12 nm to form a second electrode (cathode). Furthermore, a compound A was evaporated on the cathode to form a protective layer.

The compounds M-2, BD-1, H-1, GD-1, RD-1, H-2, E-1, and A are shown below.

Chemical Formula 1

M-2

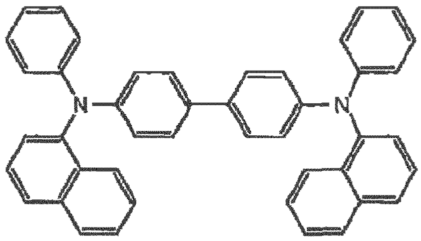

BD-1

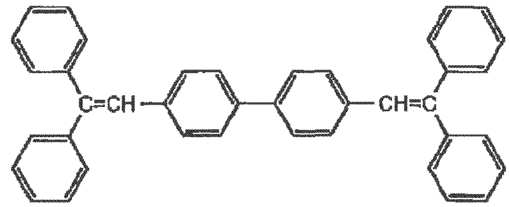

H-1

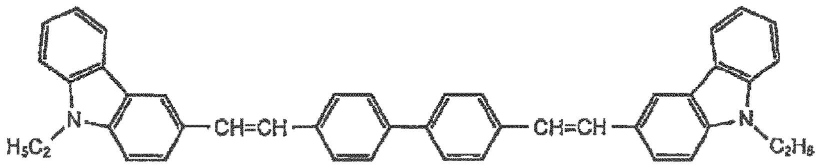

GD-1

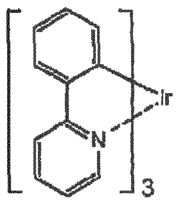

RD-1

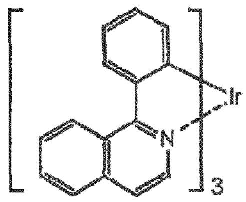

H-2

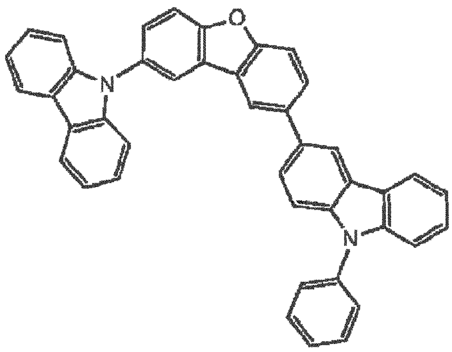

Compound A

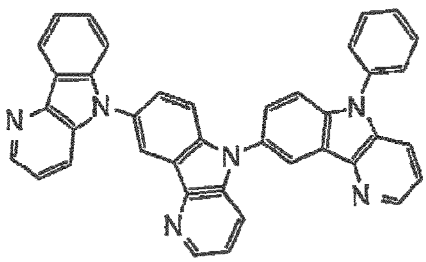

E-1

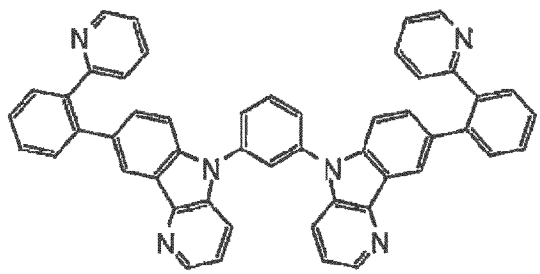

Optical Adjustment Layer

Subsequently, magnesium fluoride ($MgF_2$), which had been set in a crucible for electron gun evaporation, was evaporated using an electron gun, so that an optical adjustment layer 90 nm thick was formed on the protective layer of the organic EL element. The magnesium fluoride was evaporated at a rate of about 1 nm/sec.

Sealing Layer

A silicon nitride film was formed by a deposit-up type plasma CVD deposition apparatus under the following condition to form a sealing layer covering the entire areas (upper surfaces and side surfaces) of the organic EL element and the optical adjustment layer. The thickness of the silicon nitride film was 250 nm. The silicon nitride film to be the sealing layer was formed using the plasma CVD deposition apparatus including an electrode provided so as to be

opposed to the substrate, a high-frequency power supply that supplied plasma-excited power to the electrode, a bias supply that supplied bias power to a holding component holding the substrate, and gas supply means that supplied a carrier gas or a source gas to the electrode. Silane gas ($SiH_4$), ammonia gas ($NH_3$), nitrogen gas ($N_2$), and hydrogen gas ($H_2$) were used as the deposition gas. Supplies of such gases were set to 100 sccm for silane gas, 200 sccm for ammonia gas, 500 sccm for nitrogen gas, and 500 sccm for hydrogen gas. The deposition pressure was 50 Pa. A plasma-excited power of 3000 W at a frequency of 13.5 MHz was supplied to the electrode from the high-frequency power supply. A bias power of 500 W was supplied from the bias supply to the holding component.

Sealing Substrate and Adhesive Layer

(Preparation of Adhesive Composition)

100 mass parts of "Oppanol B50 (from BASF, Mw: 340,000)" as a polyisobutylene resin (A), 30 mass parts of "Nisseki Polybutene grade HV-1900 (from Nippon Oil Corporation, Mw: 1900)" as a polybutene resin (B), 0.5 mass parts of "TINUVIN765 (from BASF Japan Ltd., having a tertiary hindered amine group) as a hindered amine light stabilizer (C), 0.5 mass parts of "IRGANOX1010 (from BASF Japan Ltd., each of two beta positions of a hindered phenol group has a tertiary butyl group) as a hindered phenol antioxidant (D), and 50 mass parts of "Eastotac H-100L Resin (from Eastman Chemical Co.) as a cyclic olefin polymer (E) were dissolved in toluene to prepare an adhesive composition having a solid content concentration of about 25 mass%.

(Production of Sealing Component)

Alkali-free glass from Corning Incorporated, EAGLE XG, 0.7 mm thick was prepared and used as a sealing substrate. Subsequently, a solution of the prepared adhesive composition was applied onto one surface of the sealing substrate such that an adhesive layer would have a thickness of 20 $\mu$m after drying, and then dried for 2 min at 120°C to form the adhesive layer. Subsequently, a release-treated surface of a polyethylene terephthalate film 38 $\mu$m thick, which was subjected to release treatment, was attached as a release sheet to the surface of the adhesive layer to produce the sealing component. The sealing component was left for 24 hrs. or more in a nitrogen atmosphere.

(Sealing)

The sealing component was left as it is, and then the release sheet was removed from the sealing component, and the sealing component was laminated by a vacuum laminator heated to 80°C so as to cover the substrate and the sealing layer, so that the organic EL element was sealed by the sealing component. Furthermore, the sealed organic EL element was heated to 120°C for 30 min to produce the organic EL emission device of sample 101.

Production of Organic EL Emission Device of Sample 102

An organic EL emission device of sample 102 was produced using the same method as that of the sample 101 except that thickness of the light emitting unit of the organic EL element was changed based on a color adjustment prescription designed such that the chroma was smaller than that of the sample 101 by a microcavity effect.

(Color Adjustment Prescription)

A light emitting unit was produced in the same manner as the sample 101 except that a layer of the compound M-2 was formed as a hole injection transport layer at a thickness of 30 nm, and a layer of the compound A was formed as a protective layer at a thickness of 175 nm.

Production of Organic EL Emission Device of Sample 103

A filter (green absorbing filter) absorbing green was produced in the following manner and laminated as a color adjustment layer to a back side of the substrate of the organic EL emission device produced as the sample 101 using an optical adhesive sheet MO-series (thickness 50 $\mu$m) from LINTEC Corporation. The region, in which the color adjustment layer was formed, was larger than the light emitting surface of the organic EL element shown in Fig. 2.

Production of Color Adjustment Layer

(Preparation of Ink Composition for Green Absorbing Filter)

The following materials were mixed to prepare an ink composition for producing a green absorbing filter. ·Ink composition
Pentaerythritol triacrylate: 30 mass% (ultraviolet curable resin)
Glycerin: 15 mass% (coating solvent)
Triethylene glycol monobutyl ether: 3 mass% (coating solvent)
Surfynol 465: 0.3 mass% (surfactant)
Pigment green 36: 0.2 mass% (green dye)
Ethylene glycol: Residual quantity (coating solvent)

(Production of Green Absorbing Filter)

The prepared ink composition was applied by a spin coater onto a polyethylene terephthalate (PET) film (Lumirror (registered trademark) U48 from Toray Industries, Inc.) 100 μm thick, both sides of which were subjected to surface activation treatment. The coating was irradiated with ultraviolet rays of 1500 mJ by an ultraviolet exposure apparatus, and then subjected to heat treatment for 30 min at 80°C. The rotational frequency of the spin coating was adjusted such that the color adjustment layer had a transmittance of 87% at a wavelength of 550 nm.

Production of Organic EL Emission Device of Sample 104

An organic EL emission device of sample 104 was produced in the same manner as the sample 103 except that the green absorbing filter to configure the color adjustment layer was changed into a color correction filter (CC filter) CC M2.5 from FUJIFILM Corporation.

Production of Organic EL Emission Device of Sample 105

An organic EL emission device of sample 105 was produced in the same manner as the sample 103 except that the color adjustment layer was changed into a color correction filter (CC filter) CC G2.5 from FUJIFILM Corporation to produce a magenta absorbing filter.

Production of Organic EL Emission Device of Sample 106

An organic EL emission device of sample 106 was produced in the same manner as the sample 103 except that a filter (ultraviolet-absorption blue-fluorescence filter) absorbing ultraviolet rays and emitting blue light was produced in the following manner and used as the color adjustment layer.

Production of Color Adjustment Layer

A color adjustment layer was produced in the same manner as the sample 103 except that the following materials were mixed to prepare an ink composition for the ultraviolet-absorption blue-fluorescence filter. The rotational frequency of the spin coating was adjusted such that the color adjustment layer had a transmittance of 50% at a wavelength of 430 nm.

·Ink composition

Pentaerythritol triacrylate: 30 mass% (ultraviolet curable resin)
Glycerin: 15 mass% (coating solvent)
Triethylene glycol monobutyl ether: 3 mass% (coating solvent)
Surfynol 465: 0.3 mass% (surfactant)
The following compound B: 0.2 mass% (fluorescent dye)
Ethylene glycol: Residual quantity (coating solvent)

Chemical Formula 2

Compound B

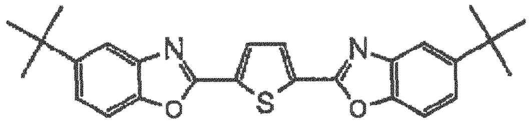

Production of Organic EL Emission Device of Sample 107

An organic EL emission device of sample 107 was produced in the same manner as the sample 103 except that a filter (blue-absorption green-emission filter) absorbing blue light and emitting green light was produced in the following manner and used as the color adjustment layer.

Production of Color Adjustment Layer

A color adjustment layer was produced in the same manner as the sample 103 except that the following materials were mixed to prepare an ink composition for the blue-absorption green-emission filter.

·Ink composition

Pentaerythritol triacrylate: 30 mass% (ultraviolet curable resin)
Glycerin: 15 mass% (coating solvent)
Triethylene glycol monobutyl ether: 3 mass% (coating solvent)
Surfynol 465: 0.3 mass% (surfactant)
Rhodamine 6G: 0.2 mass% (fluorescent dye)
Ethylene glycol: Residual quantity (coating solvent)
Table 1 shows the main configurations of the organic EL emission devices of the produced samples 101 to 107.

Table 1

| No | COLOR ADJUSTMENT LAYER | STACKING POSITION | SUBSTRATE | FIRST ELECTRODE | ORGANIC EL LAYER | SECOND ELECTRODE | SEALING SUBSTRATE |
|---|---|---|---|---|---|---|---|
| 101 | - | - | GLASS | IZO | STANDARD PRESCRIPTION | Al/Ag | GLASS |
| 102 | - | - | GLASS | IZO | COLOR ADJUSTMENT PRESCRIPTION | Al/Ag | GLASS |
| 103 | GREEN ABSORPTION | SUBSTRATE BACK | GLASS | IZO | STANDARD PRESCRIPTION | Al/Ag | GLASS |
| 104 | GREEN ABSORPTION(cc) | SUBSTRATE BACK | GLASS | IZO | STANDARD PRESCRIPTION | Al/Ag | GLASS |
| 105 | MAGENTA ABSORPTION(cc) | SUBSTRATE BACK | GLASS | IZO | STANDARD PRESCRIPTION | Al/Ag | GLASS |
| 106 | ULTRAVIOLET-ABSORPTION BLUE-FLUORESCENCE | SUBSTRATE BACK | GLASS | IZO | STANDARD PRESCRIPTION | Al/Ag | GLASS |
| 107 | BLUE-ABSORPTION GREEN-EMISSION | SUBSTRATE BACK | GLASS | IZO | STANDARD PRESCRIPTION | Al/Ag | GLASS |

Evaluation

The following evaluation was performed on each of the organic EL emission devices of the produced samples 101 to 107.

Efficiency

Luminance was measured using a voltage/current generator 6243 from ADC Corporation and a spectral radiance luminance meter CS-2000 from KONICA MINOLTA, INC. A current of 2 $mA/cm^2$ was applied to the organic EL element and luminance was measured, and the luminance was divided by the current value to determine current efficiency cd/A as efficiency. Efficiency of each organic EL emission device was evaluated by a relative value with reference to efficiency, assumed as 100, of the organic EL emission device of the sample 101.

Chroma

A spectrophotometer CM-5 from KONICA MINOLTA, INC. was used for measurement in the SCI (Specular Component Include) mode with a D65 light source to determine L*a*b* of transmitted light. Measured values in the electrode formation region were used for the chroma of the organic EL emission device. The L*a*b* was measured in the electrode formation region at five points including the center and four corners of each of the electrode formation region 21 or 23 as shown in Fig. 6, and L*a*b* of transmitted light was determined from the average of the measured values at the five points. The chroma C* was determined using the Formula (1) from the determined a*and b*. The chroma of each organic EL emission device was evaluated by a relative value with reference to chroma C*, assumed as 100, of the organic EL emission device of the sample 101.

Angular Dependence of Transmittance

A spectrophotometer U3310 from Hitachi High-Tech Science Corporation was used to determine vertical transmittances of the organic EL emission device in a wavelength range from 400 nm to 800 nm, and the average of the transmittances was obtained and denoted as T%(0). Furthermore, an attachment part was replaced, and a jig was attached such that a sample was inclined at 60° to determine transmittances at 60° of the organic EL emission device in a wavelength range from 400 nm to 800 nm, and the average of the transmittances was obtained and denoted as T%(60). Angular dependence of the transmittance was determined from [T%(60) ÷ T%(0)].

Difference in Chroma

In each of the produced organic EL emission devices, a difference in chroma was determined between the electrode formation region and the non-electrode-formation region. The value of the chroma C* of the organic EL emission device was used as the chroma $C^*_1$ of the electrode formation region. The chroma was measured in the non-electrode-formation region at any five points on the substrate 11 other than the electrode formation regions 21 and 23, and L*a*b* of transmitted light was determined from the average of the measured values at the five points. The chroma $C^*_2$ of the transmitted light in the non-electrode-formation region was determined using the Formula (1) from the determined a* and b*. The difference in chroma was determined from "electrode formation region $C^*_1$ - non-electrode-formation region $C^*_2$" as a difference between the chroma $C^*_1$ of the transmitted light in the electrode formation region, which was determined in the same manner as above, and the chroma $C^*_2$ of the transmitted light in the non-electrode-formation region.

Table 2 shows evaluation results of the efficiency, the chroma, the angular dependence of transmittance, and the difference in chroma between the electrode formation region and the non-electrode-formation region for each of the organic EL emission devices of the samples 101 to 107.

Table 2

| No | EFFICIENCY (RELATIVE VALUE) | CHROMA (RELATIVE VALUE) | ANGULAR DEPENDENCE OF TRANSMITTANCE | DIFFERENCE IN CHROMA | |
|---|---|---|---|---|---|
| 101 | 100 | 100 | 61% | 8 | COMPARATIVE EXAMPLE |

(continued)

| No | EFFICIENCY (RELATIVE VALUE) | CHROMA (RELATIVE VALUE) | ANGULAR DEPENDENCE OF TRANSMITTANCE | DIFFERENCE IN CHROMA | |
|---|---|---|---|---|---|
| 102 | 70 | 85 | 63% | 10 | COMPARATIVE EXAMPLE |
| 103 | 95 | 120 | 56% | 10 | COMPARATIVE EXAMPLE |
| 104 | 95 | 120 | 56% | 4 | COMPARATIVE EXAMPLE |
| 105 | 95 | 60 | 83% | 4 | PRESENT INVENTION |
| 106 | 98 | 62 | 81% | 3 | PRESENT INVENTION |
| 107 | 90 | 110 | 65% | 10 | COMPARATIVE EXAMPLE |

The organic EL emission devices of the samples 105 and 106, each having the color adjustment layer, have low chroma compared with the sample 101 having no color adjustment layer. On the other hand, the organic EL emission devices of the samples 103, 104, and 107, each having the color adjustment layer, have higher chroma. Thus, the chroma of the organic EL emission device cannot be reduced only by simply using the color adjustment layer such as a color filter or a fluorescent filter in the organic EL emission device. A color filter or a fluorescent filter capable of reducing the chroma needs to be selected depending on hue or chroma of the organic EL emission device to allow the color adjustment layer to function as a layer capable of reducing the chroma of the organic EL emission device.

In a configuration where thickness of the light emitting unit of the organic EL element is designed such that chroma is reduced as in the organic EL emission device of the sample 102, emission efficiency of the organic EL emission device is reduced. Generally, the organic EL element needs to be designed such that light extraction efficiency is improved by a microcavity effect in order to improve emission efficiency of the organic EL emission device. In a design prescription to reduce the chroma of transmitted light as in the organic EL emission device of the sample 102, however, since the organic EL emission device is deviated from a configuration that allows the high light extraction efficiency by the microcavity effect to be sufficiently exhibited, emission efficiency of the organic EL emission device is reduced.

If the chroma of transmitted light can be reduced at least 30% as in the organic EL emission devices of the samples 105 and 106, the difference in chroma of transmitted light during no light emission of the organic EL emission device can be reduced between the electrode formation region and the non-electrode-formation region. Hence, providing the color adjustment layer capable of reducing the chroma of transmitted light by at least 30% makes it possible to reduce variations in chroma in a plane of the organic EL emission device, and improve in-plane uniformity of the chroma. In addition, variations in transmittance can also be reduced in terms of angular dependence.

Second Example

Production of Organic EL Emission Device of Sample 201

An organic EL emission device of sample 201 was produced in the same manner as the sample 101 except that a substrate with a barrier layer and a sealing component were produced in the following manner and used.

Substrate Preparation

An antistatic layer containing an organic antistatic agent was formed on a first surface of a polyethylene terephthalate (PET) film (Lumirror (registered trademark) U48 from Toray Industries, Inc.) 100 μm thick, both sides of which were subjected to surface activation treatment.

Formation of Antistatic Layer (Organic Antistatic Agent)

A colloidal silica-containing monomer (A) was prepared according to the following method and used to prepare

an antistatic hard coat agent (A) as an organic antistatic agent. The antistatic hard coat agent (A) as the organic antistatic agent was used to form the antistatic layer.

(Preparation of Colloidal Silica-Containing Monomer (A))

30 mass parts of 2-methacryloyloxyethyl isocyanate (MOI, molecular weight 155, from Showa Denko K.K.) and 0.1 mass parts of di-n-butyltin dilaurate (DBTDL) as a catalyst were mixed to 130 mass parts of colloidal silica ($SiO_2$ content 30 mass%, average particle size 20 nm, from Nissan Chemical Corporation), and such a mixture was stirred for 24 hrs. at room temperature. A reaction of an isocyanate group was checked by an infrared spectroscopy (IR), and ethyl acetate as a solvent was removed by an evaporator to produce the colloidal silica-containing monomer (A).

(Preparation of Antistatic Hard Coat Agent (A))

5 mass% of methyl ethyl ketone solution of $Li/CF_3SO_3^-$ (nonvolatile content: 50 mass%, from Sanko Chemical Industry Co., Ltd.) was mixed to 100 mass% of the prepared colloidal silica-containing monomer (A) (nonvolatile content: 36 mass%), and such a mixture was stirred. 1 mass% of Irgacure 907 (from BASF Japan Ltd.) was added as an initiator to the mixture to prepare the antistatic hard coat agent (A) as the organic antistatic agent.

(Formation of Antistatic Layer)

Subsequently, the prepared antistatic hard coat agent (A) as the organic antistatic agent was applied onto a resin substrate and dried under a condition that thickness would be 10 μm after curing. Subsequently, the dried layer was subjected to ultraviolet irradiation at a condition of 300 mJ using a mercury lamp of 80 W/cm to form an antistatic layer including the organic antistatic agent.

Subsequently, a foundation layer 2 μm thick was formed on a second surface of the PET film. Specifically, UV curable resin OPSTAR (registered trademark) Z7527 (from JSR Corporation) was applied such that thickness would be 2 μm after drying. The coating film was dried at 80°C, and then irradiated with ultraviolet rays at an irradiation energy amount of 0.5 $J/cm^2$ using a high-pressure mercury lamp in the atmosphere.

Formation of Barrier Layer

(Silicon-Containing-Polymer-Modified Layer)

The substrate having the antistatic layer thereon was cut into a size of 120 mm × 100 mm. A silicon-containing-polymer-modified layer was formed on a surface, on which no antistatic layer was formed, of the substrate in the following manner.

20 mass% dibutyl ether solution of noncatalytic perhydropolysilazane (PHPS) (AQUAMICA NN120-20, from AZ Electronic Materials Ip Ltd) and 20 mass% dibutyl ether solution of perhydropolysilazane containing 5 mass% of amine catalyst (N, N, N', N'-tetramethyl-1,6-diaminohexane) relative to the solid content (AQUAMICA NAX120-20, from AZ Electronic Materials Ip Ltd) were mixed in a ratio of 4 : 1, and such a mixture was appropriately diluted by dibutyl ether to adjust thickness so that a coating liquid was prepared.

The coating liquid was applied onto the foundation layer by a die coater so as to have a thickness of 100 nm after drying, and dried for 2 min at 80°C. Subsequently, the dried coating film was subjected to modification treatment, i.e., was irradiated with vacuum ultraviolet rays of 2.5 $mJ/cm^2$ by a vacuum ultraviolet irradiator (from M. D. COM Inc, excimer irradiator MODEL MECL-M-1-200) with a Xe excimer lamp of a wavelength of 172 nm to form the silicon-containing-polymer-modified layer. During irradiation of the vacuum ultraviolet rays, the irradiator atmosphere was replaced with nitrogen to provide an atmosphere having an oxygen concentration of 0.1 vol%. The PET film was placed on a stage heated at 80°C while conveyance speed of the stage was 0.5 m/min.

(Silicon Compound Layer)

Subsequently, a silicon compound ($SiO_x$) layer 300 nm thick was formed on the silicon-containing-polymer-modified layer by a plasma CVD process under the following condition.
Supply of source gas (hexamethyldisiloxane: HMDSO): 50 sccm
Supply of oxygen gas ($O_2$): 500 seem
Degree of vacuum within vacuum chamber: 3 Pa
Applied power from plasma generation power source: 1.2 kW
Frequency of plasma generation power supply: 80 kHz

Film conveyance speed: 0.5 m/min

(Silicon-Containing-Polymer-Modified Layer)

Furthermore, a coating liquid containing PHPS was applied onto the silicon compound layer in the same manner as above so as to have a thickness of 300 nm after drying, and the applied liquid was dried and ultraviolet-cured to form the silicon-containing-polymer-modified layer.

Sealing Substrate and Adhesive Layer

(Production of Sealing Component)

The same one as the substrate with the barrier layer produced by the above-described method was prepared and used as the sealing substrate. After that, the adhesive layer was formed and sealed in the same manner as the sample 101 to produce the organic EL emission device of the sample 201.

Production of Organic EL Emission Devices of Samples 202 to 207

The above-described organic EL emission devices of the samples 102 to 107 were each modified such that the substrate and the sealing component were collectively changed into the substrate with the barrier layer similar to that of the sample 201, so that the organic EL emission devices of the samples 202 to 207 were produced.
Table 3 shows the main configurations of the organic EL emission devices of the samples 201 to 207.

Table 3

| No | COLOR ADJUSTMENT LAYER | STACKING POSITION | SUBSTRATE | BARRIER LAYER | FIRST ELECTRODE | ORGANIC EL LAYER | SECOND ELECTRODE | SEALING SUBSTRATE |
|---|---|---|---|---|---|---|---|---|
| 201 | - | - | PET | PHPS/SiOx | IZO | STANDARD PRESCRIPTION | Al/Ag | PET |
| 202 | - | - | PET | PHPS/SiOx | IZO | COLOR ADJUSTMENT PRESCRIPTION | Al/Ag | PET |
| 203 | GREEN ABSORPTION | SUBSTRATE BACK | PET | PHPS/SiOx | IZO | STANDARD PRESCRIPTION | Al/Ag | PET |
| 204 | GREEN ABSORPTION (cc) | SUBSTRATE BACK | PET | PHPS/SiOx | IZO | STANDARD PRESCRIPTION | Al/Ag | PET |
| 205 | MAGENTA ABSORPTION (cc) | SUBSTRATE BACK | PET | PHPS/SiOx | IZO | STANDARD PRESCRIPTION | Al/Ag | PET |
| 206 | ULTRAVIOLET-ABSORPTION BLUE-FLUORESCENCE | SUBSTRATE BACK | PET | PHPS/SiOx | IZO | STANDARD PRESCRIPTION | Al/Ag | PET |
| 207 | BLUE-ABSORPTION GREEN-EMISSION | SUBSTRATE BACK | PET | PHPS/SiOx | IZO | STANDARD PRESCRIPTION | Al/Ag | PET |

Evaluation

The organic EL emission devices of the samples 201 to 207 were each subjected to evaluation of efficiency, chroma of the organic EL emission device, angular dependence of transmittance, and a difference in chroma between the electrode formation region and the non-electrode-formation region in the same manner as in the first example. Table 4 shows evaluation results of the organic EL emission devices of the samples 201 to 207.

Table 4

| No | EFFICIENCY (RELATIVE VALUE) | CHROMA (RELATIVE VALUE) | ANGULAR DEPENDENCE OF TRANSMITTANCE | DIFFERENCE IN CHROMA | |
|---|---|---|---|---|---|
| 201 | 100 | 100 | 60% | 9 | COMPARATIVE EXAMPLE |
| 202 | 70 | 87 | 62% | 11 | COMPARATIVE EXAMPLE |
| 203 | 95 | 122 | 55% | 11 | COMPARATIVE EXAMPLE |
| 204 | 95 | 122 | 55% | 5 | COMPARATIVE EXAMPLE |
| 205 | 95 | 57 | 85% | 5 | PRESENT INVENTION |
| 206 | 98 | 59 | 84% | 4 | PRESENT INVENTION |
| 207 | 90 | 112 | 65% | 11 | COMPARATIVE EXAMPLE |

As shown in Fig. 4, results having a similar tendency to those of each organic EL emission device in the first example using glass for the substrate and the sealing substrate were also given in the organic EL emission device using the resin substrate with the barrier layer as each of the substrate and the sealing substrate. Hence, the effect of a reduction in chroma by the color adjustment layer is also exhibited in the organic EL emission device using the resin film as each of the substrate and the sealing substrate.

Third Example

Production of Organic EL Emission Device of Sample 301

An organic EL emission device of sample 301 was produced in the same manner as the sample 203 except that the color adjustment layer was formed in the following manner.

(Production of Magenta Absorbing Filter)

The following materials were mixed to prepare an ink composition for a magenta absorbing filter.

·Ink composition

Pentaerythritol triacrylate: 30 mass% (ultraviolet curable resin)
Glycerin: 15 mass% (coating solvent)
Triethylene glycol monobutyl ether: 3 mass% (coating solvent)
Surfynol 465: 0.3 mass% (surfactant)
Pigment red 254: 0.2 mass% (red dye)
Ethylene glycol: Residual quantity (coating solvent)

(Production of Magenta Absorbing Filter)

The ink composition was applied by a spin coater onto the antistatic layer on the substrate. The applied ink composition was irradiated with ultraviolet rays of 1500 mJ by an ultraviolet exposure apparatus, and subjected to heat treatment for 30 min at 80°C. The rotational frequency of the spin coating was adjusted such that the color adjustment layer had a transmittance of 87% at a wavelength of 640 nm.

Production of Organic EL Emission Device of Sample 302

An organic EL emission device of sample 301 was produced in the same manner as the sample 301 except that the color adjustment layer was formed in the same manner as the sample 106.

Production of Organic EL Emission Devices of Samples 303 and 304

Organic EL emission devices of samples 303 and 304 were produced in the same manner as the samples 301 and 302, respectively, except that the color adjustment layer was formed in a region where the amount of misregistration was equal to or within ±5% in planar arrangement of the electrode formation region and the formation region of the color adjustment layer as shown in Fig. 3.

Production of Organic EL Emission Device of Sample 305

An organic EL emission device of sample 305 was produced in the same manner as the sample 301 except that rotational frequency of spin coating was adjusted such that the color adjustment layer has a transmittance of 90% at a wavelength of 640 nm.

Production of Organic EL Emission Device of Sample 306

An organic EL emission device of sample 306 was produced in the same manner as the sample 302 except that rotational frequency of spin coating was adjusted such that the color adjustment layer has a transmittance of 70% at a wavelength of 430 nm.

Production of Organic EL Emission Devices of Samples 307 and 308

Organic EL emission devices of samples 307 and 308 were produced in the same manner as the samples 305 and 306, respectively, except that the color adjustment layer was formed in a region where the amount of misregistration was equal to or within ±5% in planar arrangement of the electrode formation region and the formation region of the color adjustment layer as shown in Fig. 3.

Table 5 shows the main configurations of the organic EL emission devices of the samples 301 to 308.

Table 5

| No | COLOR ADJUSTMENT LAYER | STACKING POSITION | FORMATION REGION | SUBSTRATE | BARRIER LAYER | FIRST ELECTRODE | ORGANIC EL LAYER | SECOND ELECTRODE | SEALING SUBSTRATE |
|---|---|---|---|---|---|---|---|---|---|
| 301 | MAGENTA ABSORPTION | SUBSTRATE BACK | FIG. 2 | PET | PHPS/ SiOx | IZO | STANDARD PRESCRIPTION | Al/Ag | PET |
| 302 | ULTRAVIOLET-ABSORPTION BLUE-FLUORESCENCE | SUBSTRATE BACK | FIG. 2 | PET | PHPS/ SiOx | IZO | STANDARD PRESCRIPTION | Al/Ag | PET |
| 303 | MAGENTA ABSORPTION | SUBSTRATE BACK | FIG. 3 | PET | PHPS/ SiOx | IZO | STANDARD PRESCRIPTION | Al/Ag | PET |
| 304 | ULTRAVIOLET-ABSORPTION BLUE-FLUORESCENCE | SUBSTRATE BACK | FIG. 3 | PET | PHPS/ SiOx | IZO | STANDARD PRESCRIPTION | Al/Ag | PET |
| 305 | MAGENTA ABSORPTION | SUBSTRATE BACK | FIG. 2 | PET | PHPS/ SiOx | IZO | STANDARD PRESCRIPTION | Al/Ag | PET |
| 306 | ULTRAVIOLET-ABSORPTION BLUE-FLUORESCENCE | SUBSTRATE BACK | FIG. 2 | PET | PHPS/ SiOx | IZO | STANDARD PRESCRIPTION | Al/Ag | PET |
| 307 | MAGENTA ABSORPTION | SUBSTRATE BACK | FIG. 3 | PET | PHPS/ SiOx | IZO | STANDARD PRESCRIPTION | Al/Ag | PET |
| 308 | ULTRAVIOLET-ABSORPTION BLUE-FLUORESCENCE | SUBSTRATE BACK | FIG. 3 | PET | PHPS/ SiOx | IZO | STANDARD PRESCRIPTION | Al/Ag | PET |

Evaluation

The organic EL emission devices of the samples 301 to 308 were each subjected to evaluation of efficiency, chroma of the organic EL emission device, angular dependence of transmittance, and a difference in chroma between the electrode formation region and the non-electrode-formation region in the same manner as in the first example. Table 6 shows evaluation results of the organic EL emission devices of the samples 301 to 308.

Table 6

| No | EFFICIENCY (RELATIVE VALUE) | CHROMA (RELATIVE VALUE) | ANGULAR DEPENDENCE OF TRANSMITTANCE | DIFFERENCE IN CHROMA | |
|---|---|---|---|---|---|
| 301 | 95 | 57 | 85% | 8 | PRESENT INVENTION |
| 302 | 98 | 59 | 84% | 6 | PRESENT INVENTION |
| 303 | 95 | 57 | 85% | 4 | PRESENT INVENTION |
| 304 | 98 | 59 | 84% | 3 | PRESENT INVENTION |
| 305 | 97 | 72 | 92% | 9 | PRESENT INVENTION |
| 306 | 99 | 74 | 91% | 7 | PRESENT INVENTION |
| 307 | 97 | 72 | 92% | 6 | PRESENT INVENTION |
| 308 | 99 | 74 | 91% | 5 | PRESENT INVENTION |

As shown in Table 6, a difference in chroma between the electrode formation region and the non-electrode-formation region is smaller in the samples 303, 304, 307, and 308, in each of which the color adjustment layer is disposed in a region having a misregistration amount equal to or within ±5% with respect to the electrode formation region of the organic EL emission device, than in the samples 301, 302, 305, and 306, respectively, in each of which the color adjustment layer is formed over the entire area of the organic EL emission device.

The color adjustment layer is formed only in the electrode formation region, which brings the chroma of the electrode formation region, in which the transmitted light has a variable color tone and easily increasing chroma, close to the chroma of the non-electrode-formation region, in which the chroma is relatively low. Hence, the electrode formation region is brought in line with the region in which the color adjustment layer is formed, making it possible to reduce the chroma over the entire area of the organic EL emission device, and reduce a difference in chroma in a plane.

A difference in chroma between the electrode formation region and the non-electrode-formation region is small in the respective organic EL emission devices of the samples 301 to 304, in each of which the chroma C* is reduced by 30% or more (relative value 70 or less) by the color adjustment layer, compared with the respective organic EL emission devices of the samples 305 to 308, in each of which a reduction in chroma C* is reduced by less than 30% (relative value more than 70) by the color adjustment. That is, even if the color adjustment layer is formed either over the entire area or over the electrode formation region as in the organic EL emission devices of the samples 301 to 304, a difference in chroma between the electrode formation region and other region can be sufficiently reduced if the reduction in chroma C* is adjusted to 30% or more (relative value 70 or less) by the color adjustment layer. For example, the organic EL emission device of the sample 305, in which the reduction in chroma C* is less than 30% (relative value more than 70), shows a difference in chroma, which is similar to that of the sample 201 having the same configuration except for the color adjustment layer, between the electrode formation region and the non-electrode-formation region. On the other hand, the organic EL emission device of the sample 301, in which the reduction in chroma C* is 30% or more (relative value 70 or less), shows a smaller difference in chroma between the electrode formation region and the non-electrode-formation region than the organic EL emission device of the sample 201 having the same configuration except for the color adjustment layer. Fourth Example

Organic EL emission devices of samples 401 to 410 were produced while a stacking position, at which the color adjustment layer was disposed, was varied in the following manner. Fig. 7 shows a stacking structure, in which the color adjustment layer was disposed, of the organic EL emission device. However, Fig. 7 shows a stacking structure of components other than the color adjustment layer. As shown in Fig. 7, the organic EL emission device includes the first barrier layer 12, the first electrode 21, the light emitting unit 22, the second electrode 23, an optical adjustment layer 31, a sealing layer 32, the adhesive layer 14, the second barrier layer 15, and the sealing base 16 stacked in this order from a substrate 11 side. In the respective organic EL emission devices of the samples 401 to 410, the color adjustment layer was disposed at respective arrow positions shown in Fig. 7. Fig. 7 also shows disposition of the color adjustment layer of each of the samples 303 and 304 for comparison in addition to disposition of the color adjustment layer of each of the organic EL emission devices of the samples 401 to 410.

Production of Organic EL Emission Devices of Samples 401 to 405

The organic EL emission devices of the samples 401 to 405 were produced in the same manner as the sample 303 except that the stacking position of the color adjustment layer was between the substrate 11 and the first barrier layer 12 (sample 401), between the first barrier layer 12 and the first electrode 21 (anode) (sample 402), between the adhesive layer 14 and the second barrier layer 15 (sample 403), between the second barrier layer 15 and the sealing substrate 16 (sample 404), or on the sealing substrate 16 (sample 405).

Production of Organic EL Emission Devices of Samples 406 to 410

The organic EL emission devices of the samples 405 to 410 were produced in the same manner as the sample 304 except that the stacking position of the color adjustment layer was between the substrate 11 and the first barrier layer 12 (sample 406), between the first barrier layer 12 and the first electrode 21 (anode) (sample 407), between the adhesive layer 14 and the second barrier layer 15 (sample 408), between the second barrier layer 15 and the sealing substrate 16 (sample 409), or on the sealing substrate 16 (sample 410).

Table 7 shows the main configurations of the organic EL emission devices of the samples 401 to 410 together with the main configurations of the samples 303 and 304 for reference.

Table 7

| No | COLOR ADJUSTMENT LAYER | STACKING POSITION | SUBSTRATE | BARRIER LAYER | FIRST ELECTRODE | ORGANIC EL LAYER | SECOND ELECTRODE | SEALING SUBSTRATE |
|---|---|---|---|---|---|---|---|---|
| 303 | MAGENTA ABSORPTION | SUBSTRATE BACK | PET | PHPS/$SiO_x$ | IZO | STANDARD PRESCRIPTION | Al/Ag | PET |
| 401 | MAGENTA ABSORPTION | BETWEEN SUBSTRATE AND BARRIER LAYER | PET | PHPS/$SiO_x$ | IZO | STANDARD PRESCRIPTION | Al/Ag | PET |
| 402 | MAGENTA ABSORPTION | BETWEEN BARRIER LAYER AND ANODE | PET | PHPS/$SiO_x$ | IZO | STANDARD PRESCRIPTION | Al/Ag | PET |
| 403 | MAGENTA ABSORPTION | BETWEEN ADHESIVE LAYER AND BARRIER LAYER | PET | PHPS/$SiO_x$ | IZO | STANDARD PRESCRIPTION | Al/Ag | PET |
| 404 | MAGENTA ABSORPTION | BETWEEN BARRIER LAYER AND SEALING SUBSTRATE | PET | PHPS/$SiO_x$ | IZO | STANDARD PRESCRIPTION | Al/Ag | PET |
| 405 | MAGENTA ABSORPTION | ON SEALING SUBSTRATE | PET | PHPS/$SiO_x$ | IZO | STANDARD PRESCRIPTION | Al/Ag | PET |
| 304 | ULTRAVIOLET-ABSORPTION BLUE-FLUORESCENCE | SUBSTRATE BACK | PET | PHPS/$SiO_x$ | IZO | STANDARD PRESCRIPTION | Al/Ag | PET |
| 406 | ULTRAVIOLET-ABSORPTION BLUE-FLUORESCENCE | BETWEEN SUBSTRATE AND BARRIER LAYER | PET | PHPS/$SiO_x$ | IZO | STANDARD PRESCRIPTION | Al/Ag | PET |
| 407 | ULTRAVIOLET-ABSORPTION BLUE-FLUORESCENCE | BETWEEN BARRIER LAYER AND ANODE | PET | PHPS/$SiO_x$ | IZO | STANDARD PRESCRIPTION | Al/Ag | PET |
| 408 | ULTRAVIOLET-ABSORPTION BLUE-FLUORESCENCE | BETWEEN ADHESIVE LAYER AND BARRIER LAYER | PET | PHPS/$SiO_x$ | IZO | STANDARD PRESCRIPTION | Al/Ag | PET |
| 409 | ULTRAVIOLET-ABSORPTION BLUE-FLUORESCENCE | BETWEEN BARRIER LAYER AND SEALING SUBSTRATE | PET | PHPS/$SiO_x$ | IZO | STANDARD PRESCRIPTION | Al/Ag | PET |

(continued)

| No | COLOR ADJUSTMENT LAYER | STACKING POSITION | SUBSTRATE | BARRIER LAYER | FIRST ELECTRODE | ORGANIC EL LAYER | SECOND ELECTRODE | SEALING SUBSTRATE |
|---|---|---|---|---|---|---|---|---|
| 410 | ULTRAVIOLET-ABSORPTION BLUE-FLUORESCENCE | ON SEALING SUBSTRATE | PET | PHPS/$SiO_x$ | IZO | STANDARD PRESCRIPTION | Al/Ag | PET |

Evaluation

The organic EL emission devices of the samples 401 to 410 and the samples 303 and 304 for reference were each subjected to evaluation of efficiency, chroma of the organic EL emission device, and angular dependence of transmittance in the same manner as in the first example. In addition, high temperature and high humidity evaluation was performed in the following manner. Table 8 shows evaluation results of the organic EL emission devices of the samples 401 to 410. Table 8 also shows evaluation results of the organic EL emission devices of the samples 303 and 304 for reference.

High Temperature and High Humidity Evaluation

An emission image of the organic EL emission device that had just been produced was taken by a commercially available microscope to determine emission area that was then denoted as S(0). Subsequently, the organic EL emission device was kept for 200 hrs. in an atmosphere of 60°C and 90% RH, and an emission image of the organic EL emission device was taken again by the commercially available microscope to determine emission area that was then denoted as S(200). Blackening area by percent of the emission region was determined using the following formula from the emission area S(0) and the emission area S(200).

$$[\text{Blackening area\%} = \{S(0) - S(200)\} / S(0)]$$

Table 8

| No | EFFICIENCY (RELATIVE VALUE) | CHROMA (RELATIVE VALUE) | ANGULAR DEPENDENCE OF TRANSMITTANCE | HIGH TEMPERATURE AND HIGH HUMIDITY EVALUATION | |
|---|---|---|---|---|---|
| 303 | 95 | 57 | 85% | 1% | PRESENT INVENTION |
| 401 | 95 | 58 | 85% | 4% | PRESENT INVENTION |
| 402 | 95 | 59 | 85% | 6% | PRESENT INVENTION |
| 403 | 95 | 57 | 85% | 4% | PRESENT INVENTION |
| 404 | 95 | 57 | 85% | 3% | PRESENT INVENTION |
| 405 | 95 | 57 | 85% | 1% | PRESENT INVENTION |
| 304 | 98 | 59 | 84% | 1% | PRESENT INVENTION |
| 406 | 98 | 62 | 83% | 3% | PRESENT INVENTION |
| 407 | 98 | 62 | 83% | 5% | PRESENT INVENTION |
| 408 | 98 | 62 | 83% | 3% | PRESENT INVENTION |
| 409 | 98 | 62 | 83% | 2% | PRESENT INVENTION |
| 410 | 98 | 59 | 84% | 1% | PRESENT INVENTION |

As shown in Table 8, if the respective organic EL emission devices include the color adjustment layers having the same configuration, a small difference in chroma occurs depending on the stacking position of the color adjustment layer in the organic EL emission device even if the stacking position varies. That is, the color adjustment layer may be stacked at any stacking position in the organic EL emission device without limitation while providing the effect of a reduction in chroma.

However, reliability of the organic EL emission device is affected by the stacking position of the color adjustment layer. This is probably because functions of the organic EL element are deteriorated due to impurity formation caused by the color adjustment layer. Specifically, when the color adjustment layer is disposed on the side toward the organic EL element with respect to the barrier layer as in the organic EL element of the sample 402, 403, 407, or 408, the reliability of the organic EL emission device is adversely affected. In particular, when the color adjustment layer is disposed at a position so as to be in contact with the electrode of the organic EL element as in the configuration of the organic EL element of the sample 402 or 407, the reliability of the organic EL emission device is most adversely affected. On the other hand, in a configuration where the sealing layer of silicon nitride is provided between the color adjustment layer and the organic EL element as in the organic EL elements of the samples 403 and 408, reliability is improved compared with the organic EL elements of the samples 402 and 407, respectively, in which the color adjustment layer is directly in contact with the organic EL element.

In light of reliability of the organic EL emission device, therefore, a layer having a high barrier property such as a barrier layer or a sealing layer is preferably provided between the color adjustment layer and the organic EL element. In particular, the color adjustment layer is preferably disposed on a more outer side than the barrier layer with respect to the organic EL element as in the organic EL emission device of the sample 303, 401, 404, 405, 304, 406, 409, or 410. The color adjustment layer is further preferably disposed on a more outer side than the substrate or the sealing substrate as in the organic EL emission device of the sample 303, 405, 304, or 410. A highly reliable organic EL emission device is provided by such configurations.

## Fifth Example

### Production of Organic EL Emission Device of Sample 501

An organic EL emission device of sample 501 was produced in the same manner as the sample 205 except that an ultraviolet absorbing filter "SC-39" from FUJIFILM Corporation was disposed as an ultraviolet absorbing layer between the color adjustment layer and the substrate.

### Production of Organic EL Emission Device of Sample 502

An organic EL emission device of sample 502 was produced in the same manner as the sample 206 except that the ultraviolet absorbing filter "SC-39" from FUJIFILM Corporation was disposed as an ultraviolet absorbing layer between the color adjustment layer and the substrate.

Table 9 shows the main configurations of the organic EL emission devices of the samples 501 and 502 together with the main configurations of the organic EL emission devices of the samples 205 and 206 for reference.

Table 9

| No | COLOR ADJUSTMENT LAYER | ULTRAVIOLET ABSORBING LAYER | SUBSTRATE | BARRIER LAYER | FIRST ELECTRODE | ORGANIC EL LAYER | SECOND ELECTRODE | SEALING SUBSTRATE |
|---|---|---|---|---|---|---|---|---|
| 205 | MAGENTA ABSORPTION | NOT PROVIDED | PET | PHPS/$SiO_x$ | IZO | STANDARD PRESCRIPTION | Al/Ag | PET |
| 501 | MAGENTA ABSORPTION | PROVIDED | PET | PHPS/$SiO_x$ | IZO | STANDARD PRESCRIPTION | Al/Ag | PET |
| 206 | ULTRAVIOLET-ABSORPTION BLUE-FLUORESCENCE | NOT PROVIDED | PET | PHPS/$SiO_x$ | IZO | STANDARD PRESCRIPTION | Al/Ag | PET |
| 502 | ULTRAVIOLET-ABSORPTION BLUE-FLUORESCENCE | PROVIDED | PET | PHPS/$SiO_x$ | IZO | STANDARD PRESCRIPTION | Al/Ag | PET |

Evaluation

The organic EL emission devices of the samples 501 and 502 were each subjected to evaluation of efficiency, chroma of the organic EL emission device, and angular dependence of transmittance in the same manner as in the first example. In addition, light resistance evaluation was performed in the following manner. Table 10 shows evaluation results of the organic EL emission devices of the samples 501 and 502. Table 10 also shows evaluation results of the organic EL emission devices of the samples 205 and 206 for reference.

Light Resistance Evaluation

Irradiation of ultraviolet rays of 40 $W/m^2$ was performed for 100 hrs. from the substrate side of each of the organic EL emission devices using Xenon Weather Meter X75SC from Suga Test Instruments Co., Ltd. After the ultraviolet irradiation, the organic EL emission device was subjected to measurement of efficiency and chroma of the organic EL emission device in the above described manner. The efficiency and the chroma of the organic EL emission device were each compared between before and after the ultraviolet irradiation.

Table 10

| No | EFFICIENCY (RELATIVE VALUE) | CHROMA (RELATIVE VALUE) | ANGULAR DEPENDENCE OF TRANSMITTANCE | LIGHT RESISTANCE EVALUATION (VARIATION IN EFFICIENCY) | LIGHT RESISTANCE EVALUATION (VARIATION IN CHROMA) | |
|---|---|---|---|---|---|---|
| 205 | 95 | 57 | 85% | 90% | 95% | PRESENT INVENTION |
| 501 | 95 | 57 | 85% | 95% | 97% | PRESENT INVENTION |
| 206 | 98 | 59 | 84% | 90% | 95% | PRESENT INVENTION |
| 502 | 98 | 59 | 84% | 95% | 97% | PRESENT INVENTION |

As shown in Table 10, the organic EL emission devices of the samples 501 and 502 having the ultraviolet absorbing layer have better efficiency and chroma after the light resistance test than the organic EL emission devices of the samples 205 and 206, respectively, having no ultraviolet absorbing layer. The ultraviolet absorbing layer therefore improves reliability of the organic EL emission device. That is, the ultraviolet absorbing layer is provided to suppress alteration of the constitutional materials of the organic EL element or the color adjustment layer by the ultraviolet rays, making it possible to maintain the efficiency of the organic EL emission device and the effect of reducing the chroma by the color adjustment layer during prolonged use.

The present invention is not limited to the configurations described in the above-described embodiment examples, and various modifications and alterations may be made within a scope without departing from the inventive structure.

List of Reference Signs

10 Organic EL emission device
11 Substrate
12 First barrier layer
13 Color adjustment layer
14 Adhesive layer
15 Second barrier layer
16 Sealing substrate
17 Ultraviolet absorbing layer
20 Organic EL element
21 First electrode

22 Light emitting unit
23 Second electrode
31 Optical adjustment layer
32 Sealing layer

## Claims

1. An organic electro-luminescence emission device, comprising a substrate, an organic electro-luminescence element, and a color adjustment layer,
wherein the color adjustment layer reduces chroma C* given by Formula (1) of transmitted light during no light emission of the organic electro-luminescence emission device compared with the chroma C* of transmitted light during no light emission of the organic electro-luminescence emission device having a configuration without the color adjustment layer.

Formula (1)

$$C^* = \sqrt{a^{*2} + b^{*2}}$$

(where a* and b* are each a color coordinate stipulated by CIE1976.)

2. The organic electro-luminescence emission device according to claim 1, wherein the color adjustment layer reduces by at least 30% the chroma C* of the transmitted light during no light emission of the organic electro-luminescence emission device compared with transmitted light during no light emission of the organic electro-luminescence emission device having the configuration without the color adjustment layer.

3. The organic electro-luminescence emission device according to claim 1, wherein the color adjustment layer is formed at a position so as to cover the entire electrode formation region of the organic electro-luminescence element.

4. The organic electro-luminescence emission device according to claim 3, wherein a formation region of the color adjustment layer is provided at a position so as to overlap with the electrode formation region, and an amount of misregistration between the formation region of the color adjustment layer and the electrode formation region is equal to or within $\pm 5\%$.

5. The organic electro-luminescence emission device according to claim 1, wherein the color adjustment layer includes at least one selected from a fluorescent material and a light-absorbing dye as a color adjuster.

6. The organic electro-luminescence emission device according to claim 1, wherein the color adjustment layer includes a dielectric thin film layer.

7. The organic electro-luminescence emission device according to claim 1, wherein a barrier layer is provided between the substrate and the organic electro-luminescence element.

8. The organic electro-luminescence emission device according to claim 7, wherein the substrate and the color adjustment layer are provided on a first surface opposite to a second surface of the barrier layer, the second surface having the organic electro-luminescence element disposed on the second surface.

9. The organic electro-luminescence emission device according to claim 7, wherein the color adjustment layer is provided on a first surface opposite to a second surface of the substrate, the second surface having the barrier layer disposed on the second surface.

10. The organic electro-luminescence emission device according to claim 1, wherein an ultraviolet absorbing layer is provided on a first surface opposite to a second surface of the substrate, the second surface having the organic electro-luminescence element disposed on the second surface.

11. The organic electro-luminescence emission device according to claim 1, wherein a second barrier layer and a sealing substrate are provided on a first surface opposite to a second surface of the organic electro-luminescence element,

the second surface having the substrate disposed on the second surface.

**12.** The organic electro-luminescence emission device according to claim 11, wherein the sealing substrate and the color adjustment layer are provided on a first surface opposite to a second surface of the second barrier layer, the second surface having the organic electro-luminescence element disposed on the second surface.

**13.** The organic electro-luminescence emission device according to claim 11, wherein the color adjustment layer is provided on a first surface opposite to a second surface of the sealing substrate, the second surface having the second barrier layer disposed on the second surface.

**14.** The organic electro-luminescence emission device according to claim 11, wherein an ultraviolet absorbing layer is provided on a first surface opposite to a second surface of the sealing substrate, the second surface having the organic electro-luminescence element disposed on the second surface.

FIG. 1

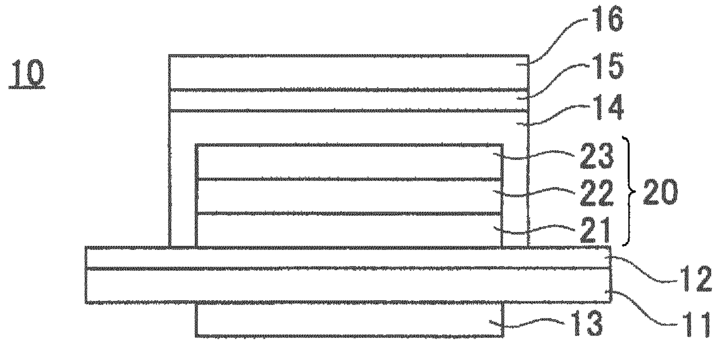


FIG. 2

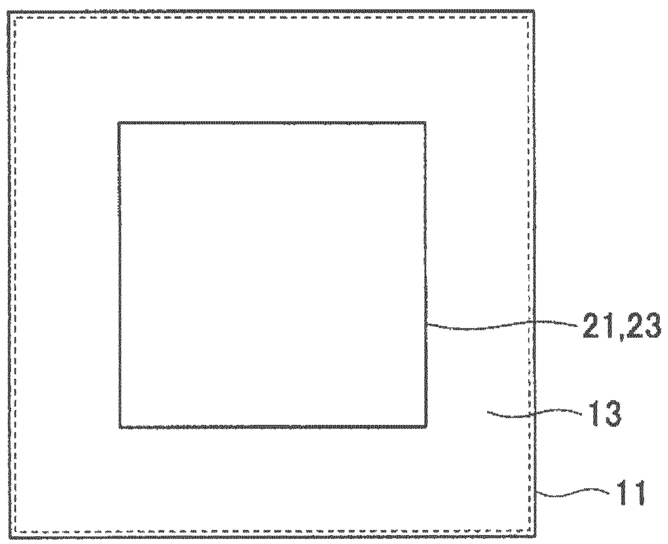


FIG. 3

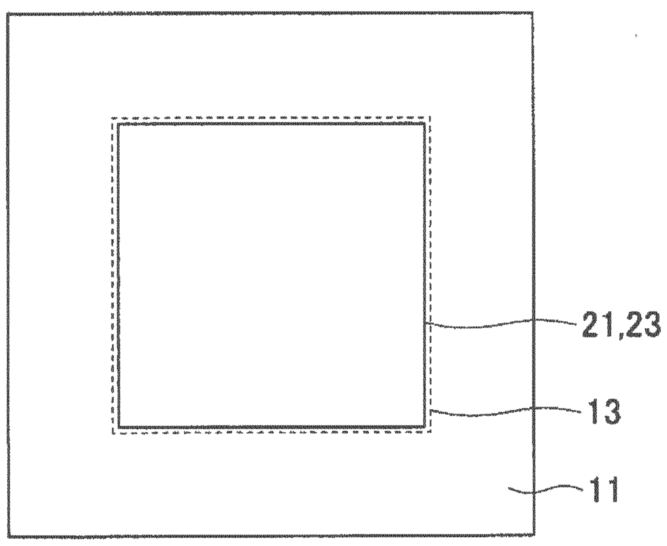

FIG. 4

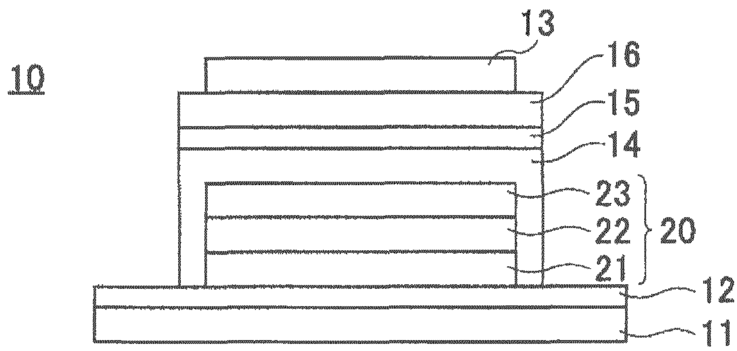


FIG. 5

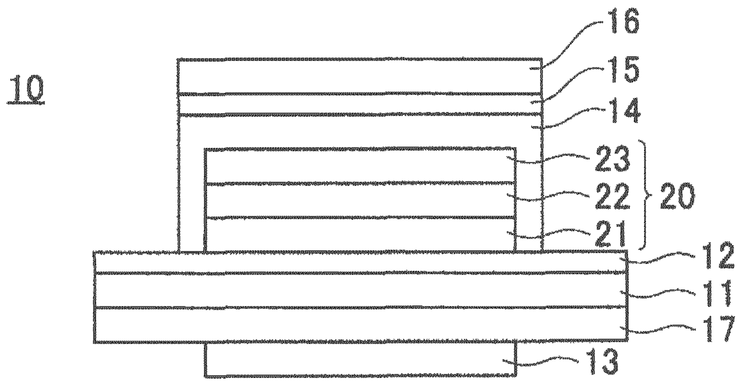

FIG. 6

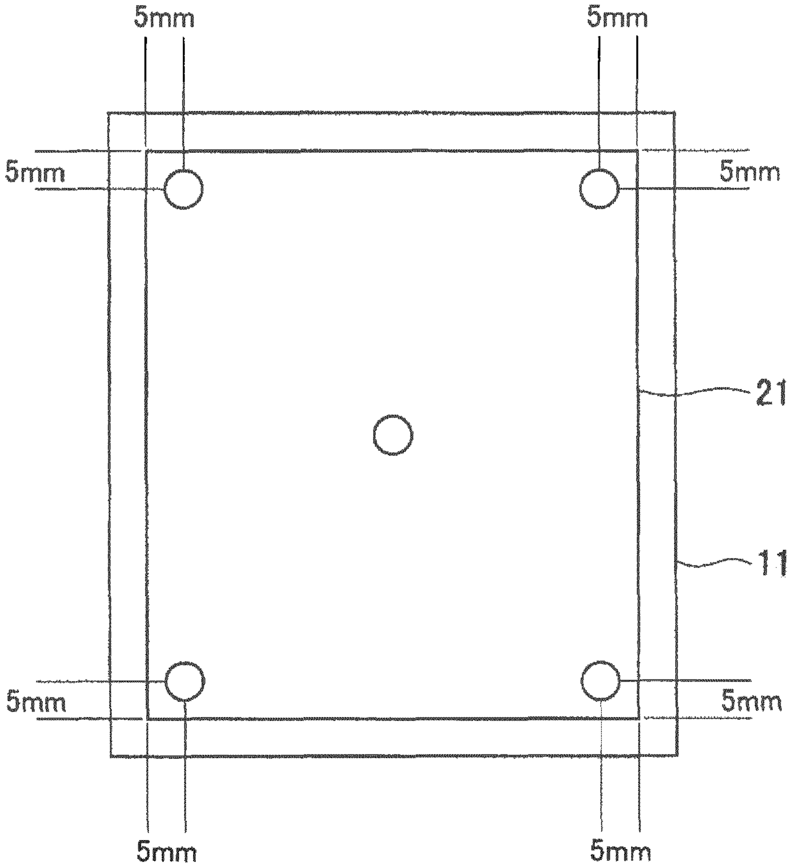
5mm
5mm
5mm
5mm
21,23
11
5mm
5mm
5mm
5mm

FIG. 7

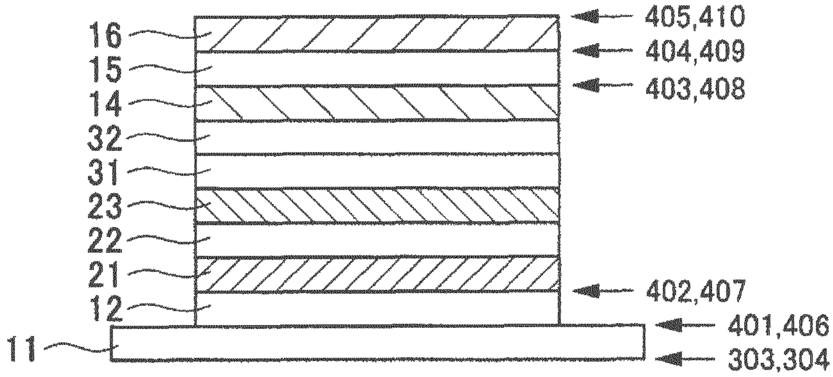
16
15
14
32
31
23
22
21
12
11
405,410
404,409
403,408
402,407
401,406
303,304

**INTERNATIONAL SEARCH REPORT**

International application No. PCT/JP2017/026424

A. CLASSIFICATION OF SUBJECT MATTER
*H05B33/12*(2006.01)i, *G02B5/20*(2006.01)i, *G02B5/22*(2006.01)i, *G02B5/28*(2006.01)i, *H01L51/50*(2006.01)i, *H05B33/04*(2006.01)i

According to International Patent Classification (IPC) or to both national classification and IPC

B. FIELDS SEARCHED

Minimum documentation searched (classification system followed by classification symbols)
H05B33/12, G02B5/20, G02B5/22, G02B5/28, H01L51/50, H05B33/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2009-70759 A (Dainippon Printing Co., Ltd.), 02 April 2009 (02.04.2009), claims 1 to 11 (Family: none) | 1-14 |
| A | WO 2013/057873 A1 (Toppan Printing Co., Ltd.), 25 April 2013 (25.04.2013), claims 1 to 4 & US 2014/0246664 A1 claims 1 to 4 & TW 201332179 A & CN 103891402 A | 1-14 |
| A | WO 2014/208435 A1 (Konica Minolta, Inc.), 31 December 2014 (31.12.2014), claims 1 to 8 (Family: none) | 1-14 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
04 October 2017 (04.10.17)

Date of mailing of the international search report
17 October 2017 (17.10.17)

Name and mailing address of the ISA/
Japan Patent Office
3-4-3,Kasumigaseki,Chiyoda-ku,
Tokyo 100-8915,Japan

Authorized officer

Telephone No.

Form PCT/ISA/210 (second sheet) (January 2015)

**INTERNATIONAL SEARCH REPORT**

International application No.
PCT/JP2017/026424

C (Continuation). DOCUMENTS CONSIDERED TO BE RELEVANT

| Category* | Citation of document, with indication, where appropriate, of the relevant passages | Relevant to claim No. |
|---|---|---|
| A | JP 2011-70921 A (Nippon Seiki Co., Ltd.), 07 April 2011 (07.04.2011), claims 1 to 4 (Family: none) | 1-14 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2007184279 A
- JP 2007264011 A
- JP 2004068143 A
- US 6337492 B
- US 7420203 B
- US 7473923 B
- US 6872472 B
- US 6107734 A
- WO 2005009087 A
- JP 2006228712 A
- JP 2006024791 A
- JP 2006049393 A
- JP 2006049394 A
- JP 2006049396 A
- JP 2011096679 A
- JP 2005340187 A
- JP 4711424 B
- JP 3496681 B
- JP 3884564 B
- JP 4213169 B
- JP 2010192719 A
- JP 2009076929 A
- JP 2008078414 A
- JP 2007059848 A
- JP 2003272860 A
- JP 2003045676 A
- WO 2005094130 A
- JP 2015060728 A